Europäisches Patentamt

European Patent Office

Office européen des brevets

(19)

(11) **EP 1 161 025 A2**

(12) **EUROPEAN PATENT APPLICATION**

(43) Date of publication:
05.12.2001 Bulletin 2001/49

(51) Int Cl.⁷: **H04L 5/02**

(21) Application number: **01120129.0**

(22) Date of filing: **08.11.1995**

(84) Designated Contracting States:
**DE FR IT**

(30) Priority: **15.12.1994  GB 9425327**

(62) Document number(s) of the earlier application(s) in accordance with Art. 76 EPC:
**95936630.3 / 0 797 878**

(71) Applicant: **Inmarsat Ltd.**
**London EC1Y 1AX (GB)**

(72) Inventors:
• **Pierzga, Wayne Francis**
**Cuffley, Hertfordshire EN6 4RG (GB)**
• **Guinand, Paul Scott**
**Nepean, Ontario K2B 7T1 (CA)**

• **Lodge, John Harrison**
**Kanata, Ontario K2L 2C9 (CA)**
• **Crozier, Stewart Newman**
**Kanata, Ontario K2K 2N9 (CA)**
• **Young, Richard John**
**Kanata, Ontario K2M 1V4 (CA)**

(74) Representative:
**Cross, James Peter Archibald et al**
**R.G.C. Jenkins & Co.,**
**26 Caxton Street**
**London SW1H 0RJ (GB)**

Remarks:
This application was filed on 22 - 08 - 2001 as a divisional application to the application mentioned under INID code 62.

(54) **Multiplexed multicarrier communication**

(57)     An OFDM communications system comprises broadcast providers 400, earth stations 100, repeater satellites 200, and receivers 300 (for example mobile receivers). The size of the multiplex can be increased by adding extra channels. Two channels are provided, on the in phase and quadrature components of each subcarrier.

FIG.1

EP 1 161 025 A2

**Description**

FIELD OF THE INVENTION

This invention relates to apparatus and methods of frequency multiplexed communication; particularly, but not exclusively, to orthogonal frequency division multiplexing (OFDM); particularly, but not exclusively, to broadcasting using such multiplexing; particularly, but not exclusively, to broadcasting digital information.

DESCRIPTION OF THE BACKGROUND ART

In frequency division multiplexing, one or more information bearing signals are communicated by modulating them onto a plurality of frequency subcarriers at different frequencies. In general, the carrier frequencies are separated by an interval at least equal to the bandwidth of the information carrying signal on each carrier frequency, although in orthogonal frequency division multiplexing (OFDM) this constraint can be relaxed slightly; in OFDM, the carriers are separated in frequency by $\Delta=1/T$, where T is the duration of each transmitted information signal, such that the centre of one band lies in the first null in the neighbouring band. Thus, although the bands around each carrier do overlap, they can nonetheless be separated by appropriate filtering as they are mutually orthogonal.
It is known to employ frequency division multiplexing together with redundant error correcting encoding, time interleaving of each information carrying signal, and distribution of each information carrying signal over the different carrier frequencies; this is disclosed in, for example, "Evaluation of error correction block encoding for high speed HF Data" - Brayer, K. and Cardinale, O.; IEEE Transactions on Communication Technology vol. COM - 15 No. 3, June 1967, "A combined coding and modulation approach for communication over dispersive channels" - Chase, D.; IEEE Transactions on Communications vol. COM - 21 No. 3, March 1973, and "Performance of selected block and convolutional codes on a fading HF channel" - Cohn D., Levesque, A.H., Meyn, J.H., Pierce, A.W.; IEEE Transactions on Information Theory, vol. IT - 14, No. 5, September 1968. More recent examples are US 4881241, US 4884139, US 5191576, US 5197061, US 5228025, US 5274629, and US 5307376.

SUMMARY OF THE INVENTION

In broadcast communications, a receiver may attempt to acquire the signal at any stage, without the transmitter being aware of this. The present invention, in one aspect, provides a frequency multiplex communication broadcast system in which the transmitter can vary the number of subcarriers in the multiplexed signal from time to time, and transmits periodically, on a particular subcarrier at a predetermined frequency, a signal specifying the number of subcarriers present in the multiplex (and, optionally, other information useful to a receiver).
Conveniently, the subcarrier carrying this information (hereafter termed the main reference subcarrier) is located at a constant frequency which forms one edge of the multiplex. Thus, the receiver is always able to acquire the data specifying the number of subcarriers, even during an existing broadcast.
Thus, transmitters are able to assign capacity amongst the different services sharing the RF link such that when more capacity is required for one service and less for another, the capacity can be dynamically reallocated. Only the bandwidth required for the currently active services is consumed, thus improving the economy of use of the RF channel.
Preferably, the main reference subcarrier is located at one edge of the multiplex, at a predetermined frequency. Since other subcarriers are located only on one side of the reference subcarrier (along the frequency axis), the amount of interference is thereby reduced where, for example, symbol synchronization (and hence orthogonality) has not been fully acquired).
Preferably, the transmitter includes a transmit filtering circuit, which can selectively apply a plurality of different filtering characteristics in dependence upon the size of the ensemble, each filtering characteristic being arranged to pass a respective ensemble size and attenuate at least some sidelobes of the outer subcarriers of the ensemble. Thus, the relatively wide spectrum of the OFDM signal is constrained to match whichever ensemble size is used. Similarly, at the receiver, additionally or alternatively, a receiver filter is provided which is set to match the size of ensemble indicated to be present by the received signal.
Preferably, each subcarrier carries a number of orthogonal data channels (for example two), each of which can be modulated independently. In the case of two channels per subcarrier, this may conveniently be achieved by providing one channel on the in phase (I) component, and the other on the quadrature (Q) component, of a complex modulator at the transmitter. Thus, when new channels are to be added, additional quadrature/amplitude constellation elements may be added to an existing subcarrier before it is necessary to add a new subcarrier. Where there are two channels per subcarrier, each subcarrier may carry either a single channel (in which case the modulation is binary phase shift keying (BPSK)) or two channels (in which case the modulation is quadrature phase shift keying (QPSK)).

Thus, conveniently, the power of each channel is the same in this embodiment.

This aspect of the invention therefore concerns a communications system, the signal generated therein, and the transmitter and receiver for respectively transmitting or receiving the signal.

Viewed another way, this aspect of the invention concerns an OFDM signal (and transmitter and receiver therefore) in which the channels carrying information are each modulated (preferably amplitude modulator) onto one of two orthogonal components on each of the subcarriers.

Another aspect of the invention concerns synchronisation. It is well known to provide synchronising information to enable a receiver to operate in synchronous mode. For example, "The AN/GSC-10(KATHRYN) Variable Rate Data Modem for HF Radio", Zimmerman & Kirsch; IEEE Trans. Commun. Tech. Vol. COM-15 No. 2, April 1967, pp. 197-204, discloses a FDM system in which a reference signal (referred to therein as a pilot signal) is placed on one quadrature channel of each subcarrier.

US 4881245 (Walker) and US 5274629 both disclose systems in which pilot or reference symbols are transmitted on selected subcarriers, at symbol periods interspersed with data symbols. Although not explicitly recognised in either document, this corresponds to orthogonal combination on each subcarrier, of the data symbol sequence, interspersed with zeros at the reference symbol periods, and a reference symbol sequence which is zero everywhere except the reference symbol periods, so that the data and reference symbol sequences are mutually orthogonal.

In another aspect, the present invention provides a system employing a frequency multiplexed signal in which the reference signal for synchronous demodulation is orthogonally combined with a data sequence and modulates at least one of the subcarriers, the orthogonal combination being such as to repeat the reference and data symbols, in different combinations, over several symbol periods within each reference symbol repetition period.

Thus, there is a spread in time over which the reference symbol is transmitted, which may under some conditions improve the protection of the reference symbols to impulse or short burst noise.

In this aspect, the combined reference and data symbols may for example be present in two symbol periods (which may be neighbouring); in this embodiment, the combination in a first of the periods may correspond to a sum of the data and reference symbols, and the combination in a second may correspond to the difference thereof.

Preferably, in this embodiment, the combination involves a scaling such that the energy of the combined symbols is the same as that of the data symbols on that or other subcarriers.

For a large number of subcarriers, the additional width of the main sidelobe of each edge of subcarrier represents a relatively small proportion of the total bandwidth. However, for one, two or three subcarriers, the extra bandwidth of one sidelobe at either side of the band represents a significant fraction of the total bandwidth required.

According to another aspect of the invention, by employing non-rectangular filters selectively for small numbers of subcarriers, higher efficiency can be made of the RF spectrum.

In another aspect, the invention is concerned with acquiring the frequency of the received signal. In this aspect, the received signal preferably carries information in symbol periods, and, repeated in a reference symbol repetition period which is a multiple of the symbol period, reference symbols of predetermined phase (e.g. constant phase, for example zero phase) are included.

It has been known to use the delay-multiply-average technique described in "Performance of a simple delay-multiply-average technique for frequency estimation", S. Crozier, K. Moreland; Canadian Conference on Elect. and Conf. Engineering (CCECE '92), Toronto, September 13-16, 1992; and "Implementation of a simply-delay-multiply-average technique for frequency estimation on a fixed point DSP", R. Young, S. Crozier; Personal Indoor and Mobile Radio Communication Conf. (PIMRC) Oct 19-21, 1992, pages 59-63 to acquire frequency estimates.

However, this technique results in frequency estimates which can be ambiguous by multiples of the reference symbol repetition frequency (the reciprocal of the reference symbol repetition period). Such ambiguity cannot be accepted under all circumstances whilst acquiring frequency, particularly in satellite communications where the Doppler effect due to satellite movement in non geostationary orbits can result in significant frequency shifts.

Accordingly, in this aspect of the invention, the received signal is sampled over fractions of each symbol period so as to pass a greater bandwidth than the symbol repetition frequency (in fact, a multiple thereof equal to the reciprocal of the fraction). First and second phase advance estimates are generated (e.g. by the delay-multiply-average process) over periods which differ by a fraction of the symbol repetition period. The difference between the two estimates can therefore provide a frequency estimate which is unambiguous over a bandwidth which is at least a multiple of the symbol repetition frequency.

A further aspect of the invention is concerned with acquiring the symbol timing in the received signal. In this aspect, the signal is modulated, between symbol periods, with guard intervals of a predetermined magnitude (which differs from the average signal magnitude). The symbol timing is extracted at the receiver in response to the presence of the guard intervals in the multiplexed signal. This may be performed independently of, and hence prior to, acquiring frequency synchronisation or the number of subcarriers present in the signal.

In a particularly preferred embodiment according to this aspect, the receiver performs long term averaging of each sample within a symbol repetition period and corresponding samples at the same temporal position within previous symbol periods (e.g. using a leaky integrator). This enables the average symbol value to be taken and compared with the average guard interval value (e.g. zero). Preferably, in this embodiment, the contrast between symbol periods and guard interval is further enhanced by high pass filtering (e.g. differentiating).

A further aspect of the invention concerns decoding a convolutionally encoded and interleaved signal. Such signals are generally coarsely quantized to a few levels (e.g. eight or nine levels) prior to decoding (e.g. Viterbi decoding). It is desirable to control the range of the quantizer to match the average range of the received samples. However, this imposes an additional delay whilst samples are accumulated in order to derive the average.

According to this aspect of the invention, we provide the quantizer range control circuitry in parallel with the deinterleaver, samples being supplied to both at the same time, so as to perform deinterleaving and quantizer range calculation at the same time, thus avoiding additional delay.

A further aspect of the invention is concerning with improving the spectral efficiency of OFDM signals. OFDM signals are attractive in that the subcarriers are spaced closely together without substantially interfering with each other due to the property of orthogonality. However, the $(\sin \chi/\chi)$ spectral shape of the OFDM subcarriers results in a very large number of relatively high amplitude sidelobes extending beyond the centre frequency of the lowest frequency subcarrier and the centre frequency of the highest frequency subcarrier. These sidelobes cannot simply be eliminated by brick wall filtering, because this would degrade the orthogonality of the signal, resulting in co-channel interference at the receiver.

Accordingly, in this aspect of the invention, the OFDM signal is filtered at the transmitter and/or the receiver so as to pass all the subcarriers and at least a portion of the first outer sidelobe of the outer subcarriers. Preferably, the transition frequency of the filter passes through the first sidelobe, so that the attenuation inherent between the first and second sidelobes of the OFDM signal assists the attenuation of the filter. Preferably, the filter has nulls positioned within each of the outer sidelobes to be attenuated, well away from the nulls between the sidelobes. Thus, the filter makes use of the attenuation already present to some extent in the OFDM signal itself. We have found that such filtering at the transmitter and preferably at the receiver greatly improves the spectral efficiency of the OFDM multiplexed signal without too greatly degrading the orthogonality thereof.

A further aspect of the invention concerns peak to mean power control of an OFDM transmitter. A characteristic of the OFDM signal is that when, exceptionally, the data on many or all subcarriers is the same the magnitude of the OFDM symbol can become very large, relative to the average magnitude of the OFDM symbols over time. This can cause either overload, and hence distortion and loss of orthogonality, at the transmitter, or excessive back off of the transmitter or satellite power amplifiers if automatic gain control is employed, which may reduce signal reception unacceptably, or reduce the level of other signals transmitted through the same amplifier.

WO 93/09619 proposes to control the peak to average power ratio by varying the synchronisation signals which are included in a quadrature amplitude modulated frequency division multiplexed signal. In "Techniques for medium-speed data transmission over HF channels", J. Pennington, IEEE Proceedings, Vol. 136 Part I, No. 1, February 1989, pages 11-19 and particularly para. 6.4, it is proposed to introduce a controlled amount of clipping in the modulator. This measure alone can lead to unacceptable distortion.

Accordingly, in this aspect of the invention, we provide a two component power control process comprising a first component process in which the magnitude of all of the OFDM subcarriers in each symbol period is controlled to evenly reduce the power of all subcarriers (thus preserving orthogonality) by reducing the power of the signal over a whole symbol period, and a second component process in which the power of only selected, high magnitude, temporal portions of the symbol period is reduced. Conveniently, the two processes may be performed in succession. In the first process, the attenuation of the signal over the whole symbol is controlled so as not to exceed some level (e.g. by employing a threshold on the attenuation applied). Thus, excessive backoff of the amplifier is avoided. Where this process is insufficient to reduce the magnitude of all subcarriers, the second process reduces the magnitude of those temporal portions (e.g. samples) which are still excessively powerful (e.g. by clipping them to a predetermined threshold) .

We have found this two stage process to be an extremely effective solution to the problem of power control, since the symbol attenuation is able to control the OFDM power without loss of orthogonality on 90% of symbols, clipping only occurring in around 10% of symbols (and on only around 0.3% of samples).

Other aspect and embodiments of the invention will be apparent to the skilled reader from the following description and claims.


BRIEF DESCRIPTION OF THE DRAWINGS

The invention will now be described, by way of example only, with reference to the accompanying drawings in which:

Figure 1 is a block diagram showing schematically the elements of a communications system according to one embodiment of the invention;

Figure 2 is a plan indicating the organisation of information channels in the system of Figure 1;

Figure 3 is a diagram showing a frequency multiplexed signal along the frequency axis, employed in the system of Figure 1;

Figure 4 is a diagram of frequency against time, indicating schematically the contents over time of the multiplexed signal of Figure 3;

Figure 5a-5c are format diagrams illustrating the time multiplexing of information-carrying signals to be modulated onto the multiplexed signal of Figure 3;

Figure 6a is a table indicating, for different arrangements of subcarriers in the multiplexed signal of Figure 3, the position in frequency of data and reference signal-carrying subcarriers;

Figure 6b is a diagram illustrating, over time, the positions of reference and data signals in the multiplexed signal of Figure 3;

Figure 7 is a diagram showing, for one of the subcarriers of Figures 3 to 6, a guard interval around each symbol;

Figure 8 is a block diagram showing schematically the elements of a transmitter station of the system of Figure 1;

Figure 9 is a block diagram showing schematically the data formatting portion of Figure 8;

Figure 10a is flow diagram showing schematically the major steps in signal encoding; and

Figure 10b is a corresponding flow diagram showing the major steps in signal decoding;

Figure 11 is a block diagram showing the contents of a byte interleaver forming part of Figure 9;

Figure 12 is a block diagram showing schematically the structure of a scrambler forming part of Figure 9;

Figure 13 is a block diagram showing schematically the structure of a convolutional coder forming part of Figure 9;

Figure 14 is a block diagram showing schematically the base band processing components of the transmitter of Figure 8;

Figure 15a is a plot of the power spectrum of the signal of Figure 3, before and after filtering, and

Figure 15b shows the frequency response to a filter forming part of Figure 14;

Figure 16a-c are block diagrams showing components of Figure 14 for processing small multiplex signals comprising, respectively, one, two or three subcarriers;

Figure 17 is a block diagram showing schematically the structure of a receiver forming part of the system of Figure 1;

Figure 18 is a block diagram showing the receiver components of Figure 17 in greater detail;

Figure 19 is a block diagram showing in greater detail the symbol timing synchronisation circuit forming part of the receiver of Figure 18;

Figure 20 is a block diagram showing the structure of a frequency tracking circuit forming part of the receiver of Figure 18;

Figure 21 is a block diagram showing in greater detail the structure of a baseband processing circuit forming part of the receiver of Figure 18;

Figure 22 is a block diagram showing in greater detail the structure of a preliminary detector forming part of the base band processing circuit of Figure 21;

Figure 23 is a block diagram showing in greater detail an acquisition circuit forming part of the receiver of Figure 18;

Figure 24 is a block diagram showing in greater detail a frequency acquisition circuit forming part of the acquisition circuit of Figure 23;

Figure 25 is a block diagram showing in greater detail the structure of a frequency estimation circuit forming part of the frequency acquisition circuit of Figure 24;

Figures 26a-c are complex plane diagrams showing the processing of signals within the circuit of Figure 25;

Figure 27 is a block diagram showing the structure of a deformatting circuit forming part of the receiver of Figure 18;

Figure 28 illustrates an alternative baseband processing circuit for coherent detection to that shown in Figure 21; and

Figures 29a-c show alternative preliminary detectors to that shown in Figure 22.


DESCRIPTION OF PREFERRED EMBODIMENT


System Overview


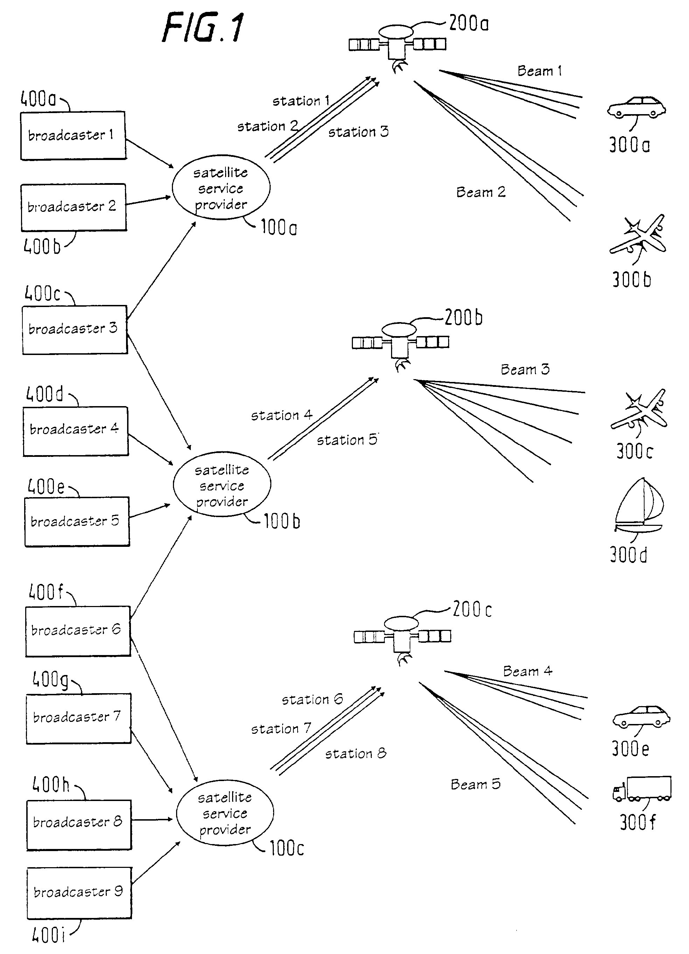

Referring to Figure 1, the system according to the present invention comprises at least one earth station, 100a, 100b, 100c, in communication with at least one repeater satellite 200a, 200b, 200c orbiting the earth, and broadcasting to at least one receiver station 300a-300f.

The earth stations 100a-100c comprise conventional satellite tracking and RF transmission components, together with the novel circuitry described hereafter. Each earth station 100a-100c is connected to one or more broadcast data sources 400a-400i, which supply, for example, digital audio channels for broadcasting, each comprising a stream of bits carrying an audio signal.

The satellites 200a-200c may be disposed in intermediate circular orbits or geostationary orbits, or in low earth orbits. Each satellite 200 is generally conventional, and operates to generate a global beam or a plurality of spot beams illuminating different regions of the earth surface beneath the satellite.

Each receiver station 300 may comprise a mobile receiver terminal within, for example, a car, a lorry, an airplane or a boat; or may comprise a fixed receiver terminal.

In addition to, or instead of, audio signals, the earth stations may also be connected to sources of data transmission for data services such as news, sport, weather and stock quote services, the data representing (for example) ASCII codes of text files. Equally, the input data signals to the earth stations 100 may carry facsimile or video data.

In the embodiment to be described, the data signals received by the earth stations 100 are of two types; firstly, data signal streams (e.g. of audio or video data) representing continuous streams of data, and secondly page-type services representing smaller files of data (such as pages of news, stock quotes and weather reports, or other data typically currently transmitted as Teletext). The latter will be referred to hereafter as datagram signals.

The bit rates for each type of data signal may range between 2 kilobits per second to 64 kilobits per second.

The frequency of the broadcast from the satellite 200 may, for example, lie within the MSS band 1524-1559 mHz or the WARC-92 BSS(S) bands 1452-1492 mHz and 2655 to 2670 mHz.

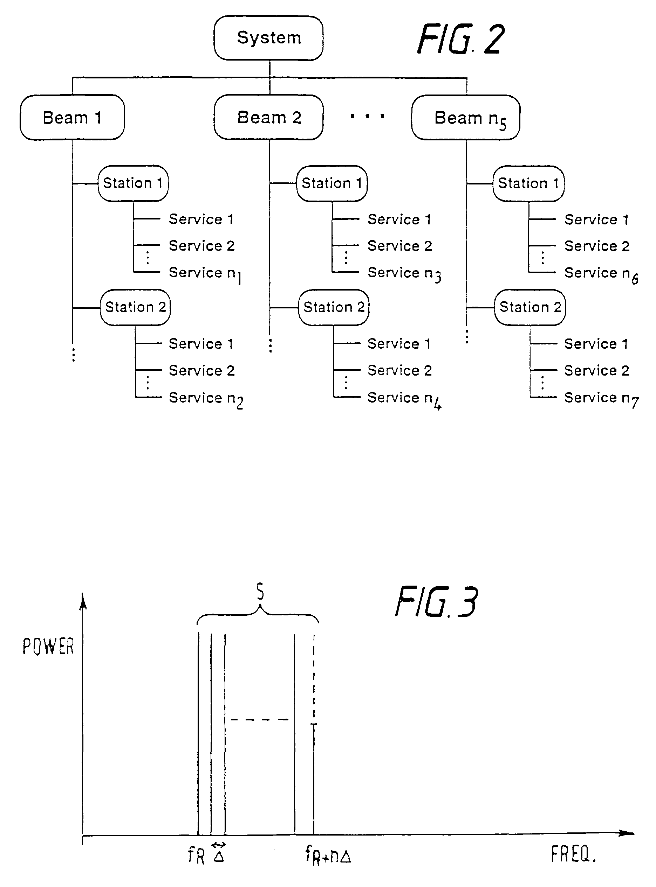

Referring to Figure 2, each beam generated by each satellite 100 carries at least one OFDM multiplexed signal, each multiplexed signal being referred to hereafter as a "station" (by way of analogy with a conventional analogue radio station). Each such station carries one or more services, each corresponding to an information signal input to the earth station 100. One service may occur on several beams, to achieve a desired regional or global coverage. Each composite multiplexed OFDM signal is adjustable, to alter the data rate and bandwidth, as will be discussed in greater detail below. Thus, the requirements of the broadcast system can be adjusted to account for a change in the number of services, or bandwidth required for each service.

Signal format

Referring to Figure 3, in this embodiment the transmitted multiplexed signal S comprises a plurality of subcarrier signals, at subcarrier frequencies evenly spaced by $\Delta$, where $\Delta$ is the increment for orthogonal frequency displacement. Each frequency f can carry either one or two channels. The number of channels is variable, in use, by varying the number of subcarrier frequencies and by varying the number of channels on each frequency. One subcarrier (the reference subcarrier hereafter) is always present, at a predetermined frequency $f_R$. The number of other subcarriers is variable, and each additional subcarrier occupies a progressively higher frequency. It is possible for the highest frequency subcarrier (i.e. the outer edge subcarrier) to carry either one channel or two channels; all other subcarriers carry two channels. In this way, bandwidth usage is kept to a minimum.

All subcarriers carrying two channels (that is to say, all except the extreme edge subcarrier, and possibly that too) are modulated using quadrature phase shift keying (QPSK). One bit from channel modulates the in phase (I) component of the subcarrier, and one bit from the other channel modulates the quadrature (Q) component, to produce the following bit/symbol mapping:

| Bits (ordered bit(t),bit(t+1)) | Complex symbol,c $\mid c \mid^2 = 1$ |
|---|---|
| 00 | +I+j |
| 01 | +I-j |
| 10 | -I+j |
| 11 | -I-j |

Where the extreme edge subcarrier carries only one channel (as shown in Figure 3) the bits from the channel modulate the in phase (I) component, to produce the following bit/symbol mapping:

| Bits (ordered bit(t),bit(t+1)) | Complex symbol,c $\mid c \mid^2 = 1$ |
|---|---|
| 1 | +I |
| 0 | -I |

Thus, where a single carrier is present, the modulation is BPSK. The energy of the signal on a subcarrier carrying only one channel is thus half that of the energy of a subcarrier carrying two channels; i.e. in every case, the energy of the multiplexed signal S is proportion to the number of channels c present.

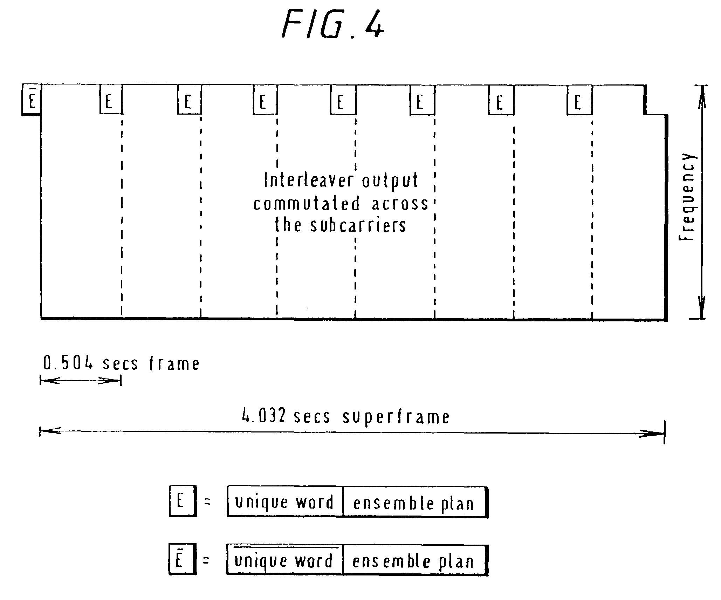

Referring to Figure 4, the multiplexed signal S is transmitted in a regular time-divided fashion, consisting of frames of data each of duration 0.504 seconds and superframes comprising eight such frames and of duration of 4.032 seconds. The superframe length is of the order of several seconds, to permit time interleaving, to distribute burst errors over time and frequency as will be discussed in greater detail below.

Each frame is preceded by the transmission, on the reference frequency $f_R$, of a data signal indicating the current allocation of subcarriers and channels, referred to herein as the "ensemble plan" (EP). Since the number of channels is variable, this information is required by the receiver prior to full reception of the multiplexed signal. In this embodiment, eight bits are required for describing the number of channels, (i.e. half subcarrier increments); and various other bits are used as flags to indicate parity options, coding options and so on, to a total of 42 bits.

The ensemble plan data is prefixed by a so-call "unique word", being a low autocorrelation code word uniquely recognisable by the decoder; for example, a 32 bit word. Prior to the frame which precedes the start of the next superframe, rather than transmitting the unique word, the binary complement of the unique word is transmitted. Thus, by detecting unique words, the receiver can determine frame and superframe boundaries, and subsequently derive the data describing the format of the multiplexed signal S, from the reference subcarrier $f_R$.

The remaining data transmitted within each superframe consists of a time multiplexed format of system information, datagram signals, and stream signals.

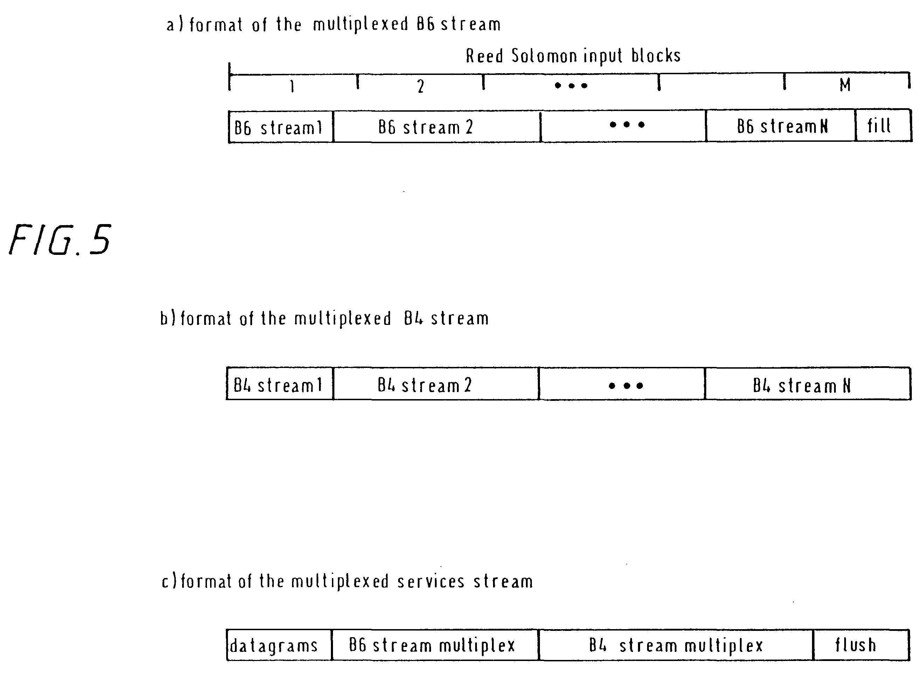

Referring to Figure 5, Figure 5a indicates the format of the multiplexed bit stream, comprising packets of system information, followed by packets of datagram signals, followed by a multiplex of one or more streams encoded to provide a minimum bit error rate (BER) of $10^{-6}$ (labelled B6), followed by a multiplex of one or more information streams encoded to provide a minimum bit error rate (BER) of $10^{-4}$ (labelled B4).

The datagram signals (or, at any rate, those which carry system information) are transmitted repeatedly within each superframe, to minimise the impact of channel errors (since the datagrams are not encoded). Carried within the datagram traffic within reserved time channels are the following particular system plan datagrams:

> (a) beam plan datagram
> (b) station plan datagram
> (c) service plan datagram

These packets carry the information shown in Figure 2, enabling the receiver to be aware of which satellite beams are carrying which stations (to enable the user to orient an antenna correctly, and to indicate the coverage area for stations within each beam) within the beam plan datagram; a list of the transmitting stations specifying beam, frequency, station name, station description and timing information in the station plan datagram; and a list of the services with names, descriptions, timing information (for example, service start and finish times), beam and channel information on the service plan datagram.

Referring to Figure 5b, the B4 multiplex consists of a concatenation of some of the input streams received at the earth station 100. Referring to Figure 5c, the B6 multiplex is formed by, firstly, concatenating the input streams received at the earth station 100 (as shown in Figure 5a) and, secondly, encoding the concatenated stream of Figure 5a and interleaving the encoded stream (as will be described in greater detail below).

The multiplexed bit stream shown in Figure 5a is then distributed across the channels of the signal S, to form the OFDM multiplexed signal.

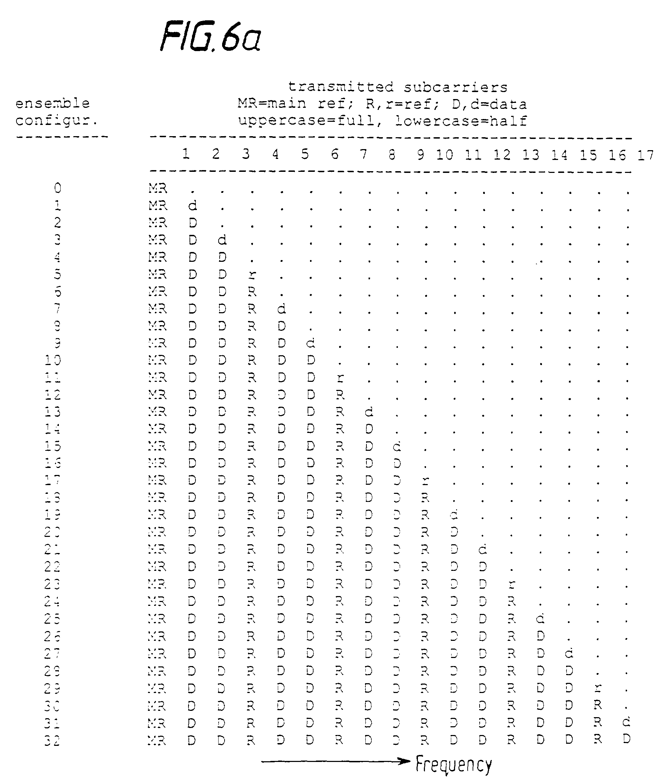

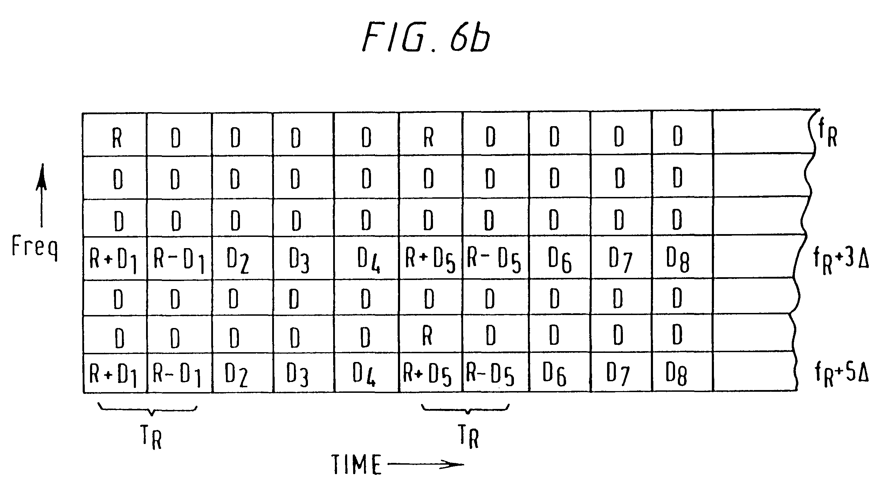

Referring to Figure 6, the multiplexed signal contains reference or pilot components, which enable a receiver to use synchronous detection. The reference signals comprise periodically transmitted samples which are known to the receiver; conveniently, the samples may all have the same value, as in this embodiment (but the possibility of employing different samples at different times is not excluded).

Referring to Figure 6a, the distribution in frequency of the reference samples is shown. Figure 6a illustrates the availability of different configurations for the multiplexed signal, varying from configuration 0 (in which only the main reference subcarrier is present) upwards. Each ensemble configuration corresponds to one channel additional to the immediately preceding ensemble configuration; thus, an additional frequency subcarrier is added each two ensemble configurations. For odd numbered ensemble configurations, the outer subcarrier (i.e. that furthest away in frequency from the main reference subcarrier) carries only one channel and is encoded in BPSK format.

The main reference subcarrier carries, in every fifth symbol period (as shown in Figure 6b), a reference symbol consisting of a sample at a reference phase (for example $0°$) and, for example, at the same amplitude as the data symbols.

One every third subcarrier from the main reference subcarrier, reference data is carried, in the form of a pair of modified symbols each consisting of a combination of the data symbol and a reference symbol (for example a sample at zero phase).

As shown in Figure 6b, the form of the combination is, in this embodiment, a sample comprising the sum of the data symbol and the reference symbol in one symbol period, and a sample consisting of the difference between the two in the next symbol period. Thus, at a receiver, the data symbol can be recovered by forming the difference between the two adjacent symbol period samples, and the reference symbol can be recovered by forming the sum thereof.

To normalise the power in the symbol period, preferably, the first combined symbol is formed as the sum of $(R/\sqrt{2} + D_1\sqrt{2})$ and the second symbol is formed as the sum of $(R\sqrt{2} - D_1\sqrt{2})$, where R is the reference symbol and $D_1$ is the data symbol to be transmitted. Thus, the power in the two combined symbol periods on each subcarrier is the same as in the adjacent subcarriers of the preceding or succeeding data samples in the same subcarrier.

Thus, the signal on the reference subcarriers consists of the sum of the data symbol sequence $D_1$, $D_2$ ... and a sequence of reference symbols R, the reference symbol values being zero for three successive values, and equal to R for two intervening values.

Orthogonality between the two sequences is maintained by the fact that, for the non zero reference symbols, Manchester encoding (i.e. the data symbol followed by the negated data symbol) is employed, and the amplitudes of the data and reference symbols are normalised.

In other embodiments, rather than conveying reference signal information on two combined samples, the reference signal information may be spread over a larger number of symbol periods. It will be seen that the above described embodiment provides a 2 x 2 Hadamard matrix, with one row used to code the reference symbol, and the other to code the data bearing symbol, as follows:

$$\begin{pmatrix} 1 & -1 \\ 1 & 1 \end{pmatrix}$$

normalised by the scaling factor of $\sqrt{2}$.

If it is desired to spread the reference signal over more symbol periods, a larger Hadamard matrix (e.g. 4 x 4) may be used, with three rows for three data bearing symbols, and one row for the reference symbols. In this case, only one symbol period out of every five, on a reference subcarrier, would carry data, the rest carrying combined data and reference symbols.

As shown in Figure 6a, for odd numbered multiplex configurations, where the outermost subcarrier is a reference subcarrier, binary phase shift keying rather than quadrature phase shift keying is used to combine the reference symbol with one data bit. This is represented by a 'r' in Figure 6a.

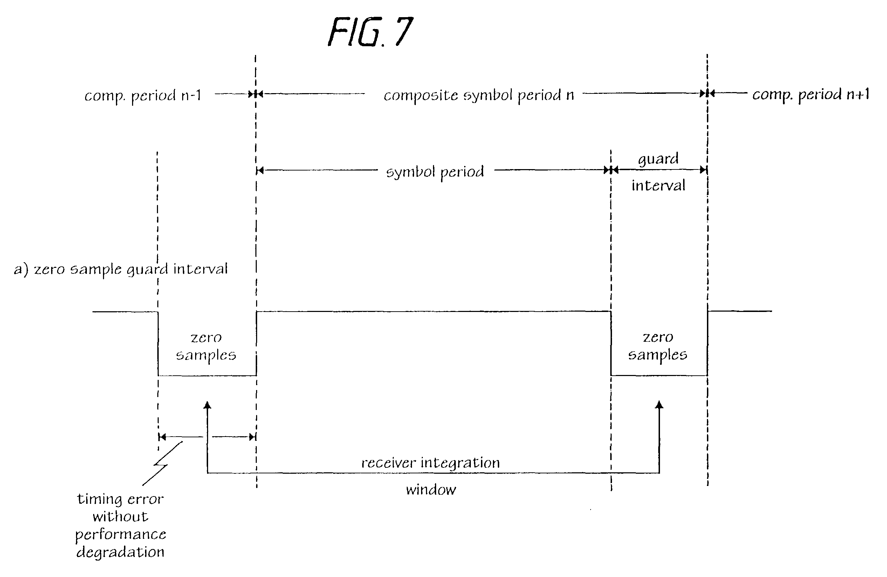

Referring to Figure 7, on every subcarrier, the bit stream is interrupted between every symbol to provide a guard interval of duration 1/8 that of each symbol, in which the carrier level is set to zero. This enables some relief from the effects of time dispersion in the transmission path, and symbol timing error at the receiver 300.

Earth station and transmitter structure

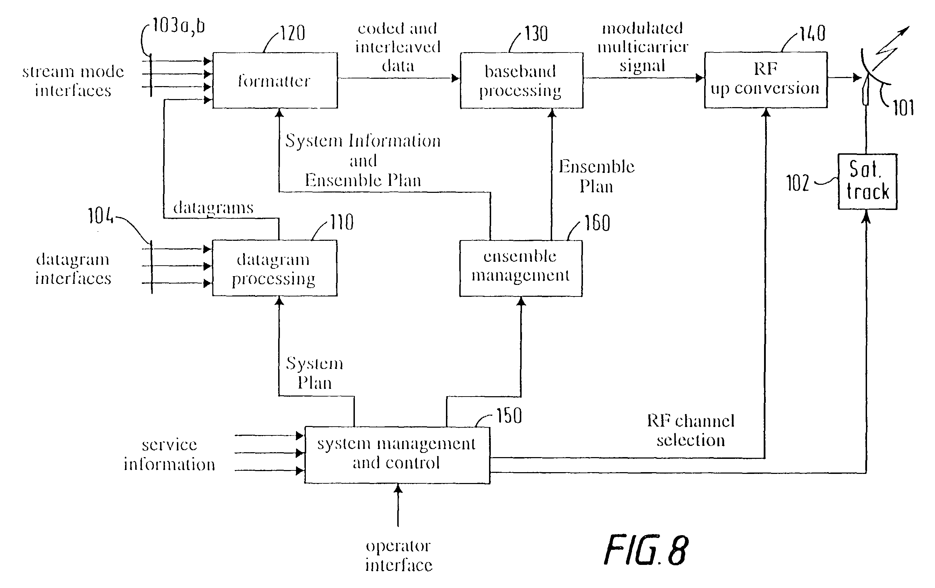

Referring to Figure 8, the earth station 100 comprises, in addition to conventional components such as the uplink antenna 101 and tracking system 102, input ports 103 for receiving information signal streams from broadcasters, and input ports 104 for receiving information signal datagrams from broadcasters.

The datagram signals are packetised in a data processor 110, and datagram packets are supplied, together with the information signal streams received at the stream interfaces 103, to a formatting circuit 120, which multiplexes, encodes and interleaves the information signals (together with system information) to provide a data stream which is supplied to a base band processing section 130. Within the baseband processing section 130, the data stream is modulated onto the subcarriers at baseband. The frequency multiplexed baseband signal is then supplied to an RF up-convertor circuit 140, and transmitted via the uplink antenna 101 to the satellite 200.

A system control circuit 150 (e.g. a programmable processing device such as a microcontroller) determines the necessary number of channels and subcarriers, and the allocation of services, and supplies system information to the datagram processing circuit 110 to be encoded as datagrams for broadcasting. The system control circuit 150 also supplies the necessary number of carriers to an ensemble management circuit 160 (for example another, or the same, microcontroller) which generates a corresponding ensemble plan, which is supplied to the baseband processing circuit 130 to be modulated onto the reference subcarrier.

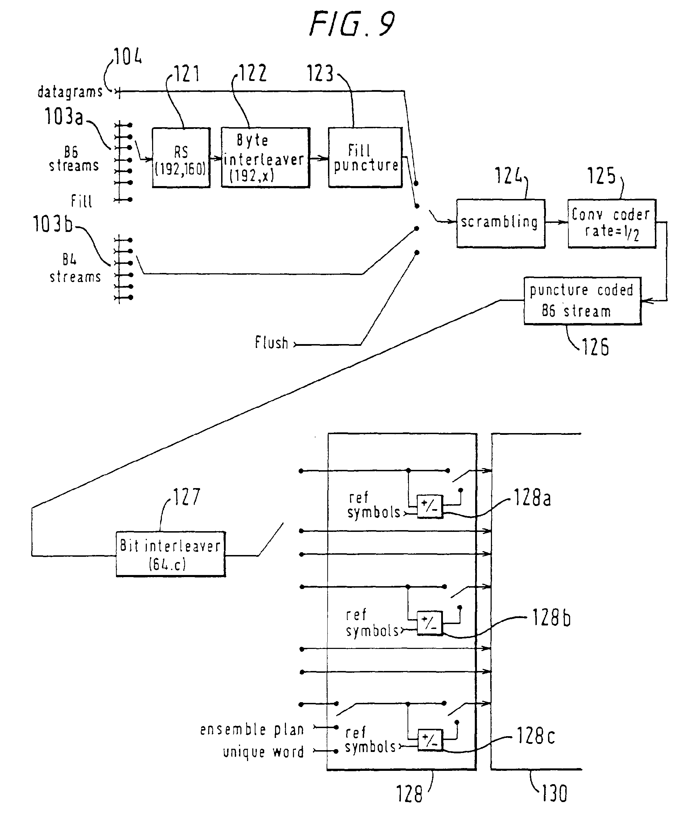

Referring to Figure 9, the operation of the formatting circuit 120 will now be described in greater detail.

The formatter 120 comprises an error correction (redundant) encoder (in this embodiment, a Reed-Solomon (192,160) encoder 121); a byte interleaver (in this embodiment a Reed-Solomon (192,x) byte interleaver) 122; and a puncturing circuit 123 which shortens the code for the last Reed-Solomon block in a superframe to a (M+32,M) code (where M is less than 160 bytes).

This last circuit is desirable because the B6 stream from input port 103a will not receive exactly enough bytes to fill an integer number of 160 bytes Reed-Solomon blocks, and so it is necessary to supply additional fill bytes (e.g. set to zero) to pad the stream up to the closest multiple of 160 bytes. By truncating the code in the last block, however, it is possible to lessen the wastage by not transmitting the fill bytes.

The Reed-Solomon coder 121 may be the L64711 ASIC available from LSI Logic in the US.

The (192,160) code is shortened from 255,233 code, i.e. a code over GF (256), the Galois field with 256 elements, whose generator polynomial is:

$$g(\chi) = \prod_{i=0}^{31} (\chi + \alpha^i)$$

where $\alpha$ is a root of the binary primitive polynomial:

$$\chi^3 + \chi^4 + \chi^3 + \chi^2 + 1$$

The Reed-Solomon encoding is synchronised to each superframe.

The byte interleaver comprises a memory and associated addressing circuitry and will be discussed below.

The fill puncture circuit 123 is provided by a microprocessor or other address control circuit arranged to remove contents of the byte interleaver 122.

The B6 streams from input port 103a are switched, in sequence, to the encoder 121 as illustrated in Figure 5c. The B4 streams from input port 103b are concatenated together as shown in Figure 5b, and concatenated together with datagrams from the datagram input port 104 and encoded data from the B6 encoding circuit comprising circuits 121-123, to provide the combined bit stream shown in Figure 5a.

The combined bit stream is supplied to a scrambler circuit 124, the output of which passes through a rate ½ convolutional coder 125 and a code puncturing circuit 126 operating selectively on the B6 stream portions of the combined bit stream to reduce the B6 stream to ½ coding rate. The scrambled, encoded composite bit stream thereafter passes to a bit interleaving circuit 127 (in this embodiment a (64,c) interleaver, where c is the number of channels present) which distributes the bits of the bit stream over the channels to be modulated onto the subcarriers within the baseband processing circuit 130.

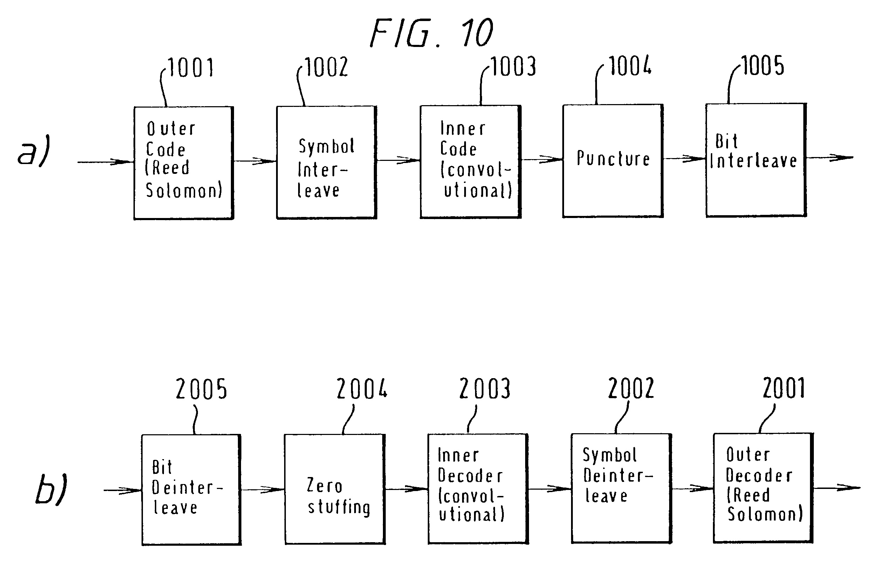

Aspects of the formatting circuit 120 will now be discussed in greater detail. Figure 10a illustrates the encoding for the B6 stream. The encoding comprises inner and outer encoding steps 1003, 1001, the convolutional code representing the inner stage and the Reed-Solomon code the outer stage.

Since the convolutional code is applied also to the B4 stream, to simplify multiplexing together the B4 and B6 streams, the two coder rates applied to the two streams are made (at least approximately) the same. The rate of the convolutional coder 125 in this case is ½, and consequently it is desired to make the combined rate of the Reed-Solomon and convolutional coder applied to the B6 stream ½ also.

Thus, the puncturing circuit 126 is arranged to puncture the output of the convolutional coder 125 (step 1004), taking account of the rate of the Reed-Solomon coder 121. Thus, in this embodiment, since the rate of the Reed-Solomon coder 121 is (160/192), the rate of puncturing is 2 bits in every 12 bits, resulting in an increase in the data rate of (6/5)=(192/160).

The puncture mask for the B6 data is given in the following table, and spans 12 bits out of the convolutional encoder; code puncturing begins when the seventh B6 byte has entered the convolutional encoder and continues right to the end of the B6 stream.

| code generator | t | t+1 | t+2 | t+3 | t+4 | t+5 |
|---|---|---|---|---|---|---|
| 133 | | | X | | | |
| 171 | X | | | | | |

Further operation of the puncture circuit 126 is described in "Rate-compatible punctured convolutional codes (RSPC codes) and their applications", Hagenauer, J.; IEEE Trans. COMMUN., vol 36. PP 389-400, April 1988.

The interleaver 122 (stage 1002) is positioned between the outer encoder 121 and the inner encoder 125 because of the tendency of a convolutional encoder to result in error bursts if an error occurs in the channel.

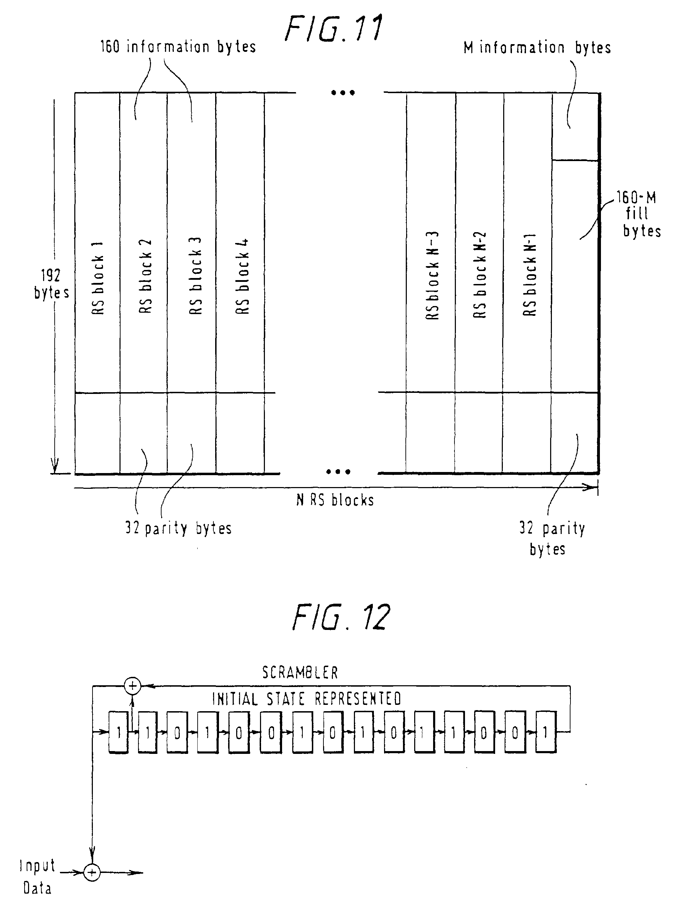

The contents of the RAM memory device comprising the interleaver 122 is shown in greater detail in Figure 11.

The interleaver 122 has 192 rows, and a number of columns equalling the number of blocks required for the superframe. The coded bytes from the coder 121 are read in sequence, column by column into the interleaver 122, and read out across the rows, taking one byte from each of the 192 byte coded blocks (corresponding to the columns) as each row is read.

The block interleaving applied is selectable in four different spans; it may be one, two, four or eight frames (i.e. one superframe) in duration. Data is read out across the rows. The final column is, in general, never completely filled. When reading a row where the final column is not filled, the final byte position is skipped. The next row to be read is determined from the two permutation equation given by:

$$Rj=(Ri*27) \bmod 64$$

where Rj is the next visible row to read and Ri is the logical index of the row to be read which goes from 0 to 63 in increment of 1.

The bit interleaver 127 simply distributes the incoming bits amongst the channels available (i.e. two bits to each subcarrier or one or two bits to the outermost edge subcarrier) at input ports of the baseband processing section 130. A reference symbol adding circuit 128 comprises combining circuits 128a,128b,128c ... for the reference subcarriers, arranged to pass three channel pairs of data bits, and then, on each fourth symbol period, to form the complex sum of the forth pair of data bits and the reference symbol (e.g. a zero phase symbol, (0,1)), each divided by √2; and, in the fifth symbol period, to form the difference between the same pair of data bits and the reference symbol (again, each divided by √2).

The combining circuit 128 also multiplexes the unique word and ensemble plan into the main reference subcarrier once every frame (i.e. every half second), and the inverse unique word and ensemble plan once every superframe period (i.e. once every four seconds).

Referring to Figure 12, the scrambler circuit 124 in this embodiment is a non-self synchronising scrambler implemented with a feedback shift register acting as a pseudo random byte generating. The feedback polynomial for the shift register is $1+X+X_{15}$. The bits thus generated are added to the input data, bitwise. The scrambling has the effect of spreading the spectrum of the signal, and also provides some level of privacy against accidental reception. The initial state of the scrambler 124 is reset at every interleaver block to the value shown in Figure 12. The descrambler at a receiver needs to have the same structure and to have the same initial bit sequence.

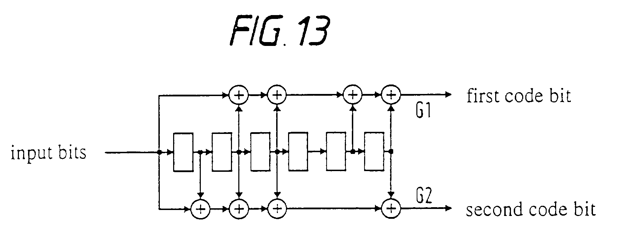

Referring to Figure 13, the convolutional encoder is a well known half rate coder with polynomials $G1=133_8$ and $G2=171_8$. The bit resulting from the G1 stream (the first code bit) is transmitted before the byte resulting from the G2 stream (second code bit). The convolutional encoder is set to the all zero state at the start of each superframe, and is flushed with a sequence of 8 zero bits at the end of each interleaver block.

As is conventional, the convolutional encoder comprises a delay line tapped at various points, from which taps the bits are added to one of two branches created from the input bit stream, to create two output bit streams which are alternately selected, so as to double the bit rate relative to the input bit stream.

For example the STEL-2040 ASIC available from Stanford Telecommunications, 2421 Mission College Boulevard, Santa Clara, California, U.S.A. may be employed.

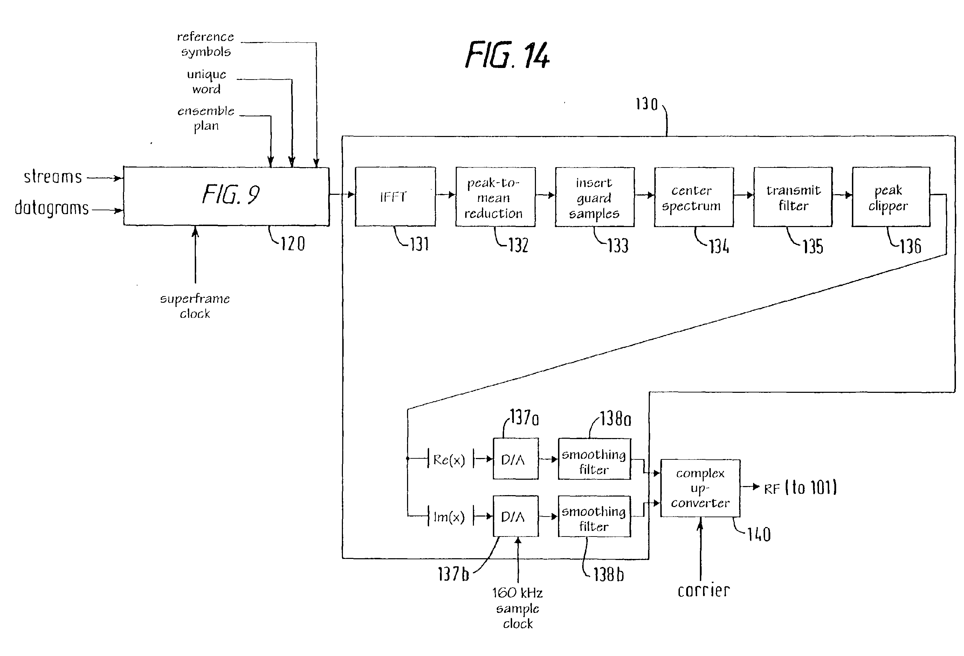

Referring to Figure 14, the baseband processing circuit 130 will now be described in greater detail. The processing is performed chiefly by digital signal processing (DSP) components such as the Motorola DSP 5600 or Western Electric DSP 32C, with an output sample rate of 160 kHz.

The baseband processing comprises firstly, an Inverse Fast Fourier Transformer 131 (for example, operating a 32 point IFFT).

As is well known, the Inverse Fast Fourier Transform (IFFT) will, when provided with an input data stream corresponding to the complex signal amplitude at each of a plurality of spaced frequencies, generate a frame of digital samples representing the complex time domain signal containing these spectral components. In other words the IFFT device 131 frequency multiplexes the input channels into a frequency multiplexed time domain signal comprises real and imaginary digital components.

The main reference subcarrier is provided as the first entry to the IFFT device 131 of the 32 point complex vector input thereto; the next subcarrier is the second entry, and so on. In the corresponding time domain output signal generated by the IFFT device 131, the main reference subcarrier component is centred at 0 Hz. The spacing between the subcarriers is Δ=5kHz, for a data rate of 160kHz, and each subcarrier has a (sin x)/x spectrum, with lobes of one carrier lying in nulls of the neighbouring carriers.

Next, the series of 32 samples making up the wave form corresponding to one symbol period is processed by a peak-to-mean reduction circuit 132, to alleviate the problem either of distortion and intermodulation, or of transmitter power reduction, which can occur where samples within the symbol period have an excessively high peak value compared to the average sample level. The peak-to-mean reduction circuit 132 detects whether any samples within the symbol period are in excess of a predetermined threshold and, if so, the magnitude of all samples within the symbol period is reduced evenly, so as to reduce the magnitude of the symbol. Thus, orthogonality is generally preserved. To avoid excessive attenuation of the symbol, however, the amount of attenuation to the samples is constrained not to exceed a maximum value of -3dB.

The resulting complex signal is supplied to a guard sample insertion circuit 133, which inserts 4 zero valued samples after each 32 symbol samples, to produce the wave form shown in Figure 7.

The symbol rate following the guard sample insertion circuit 133 is 5000*32/36Hz, or roughly 444.44Hz.

Next, a down-convertor circuit 134 frequency shifts the baseband signal down so that it is centred around 0Hz. The amount of frequency shift is equal to (n-1) $\Delta$/2, where n is the number of subcarriers present in the multiplex. The object of the frequency shift executed by the down converter 134 is to centre the signal within the pass band of a (lowpass) transmission filter 135, which band limits the OFDM signal (which is, otherwise, associated with high sidelobes).

The transmit filter 135 comprises a FIR filter, the coefficients of the filter being variable in dependence upon the number of subcarriers employed. In the present embodiment, 23 or 25 tap filters were found to be sufficient. The filter is arranged to pass at least part of the first sidelobe of the multiplexed signal, so as to avoid excessive degradation to the edge subcarriers.

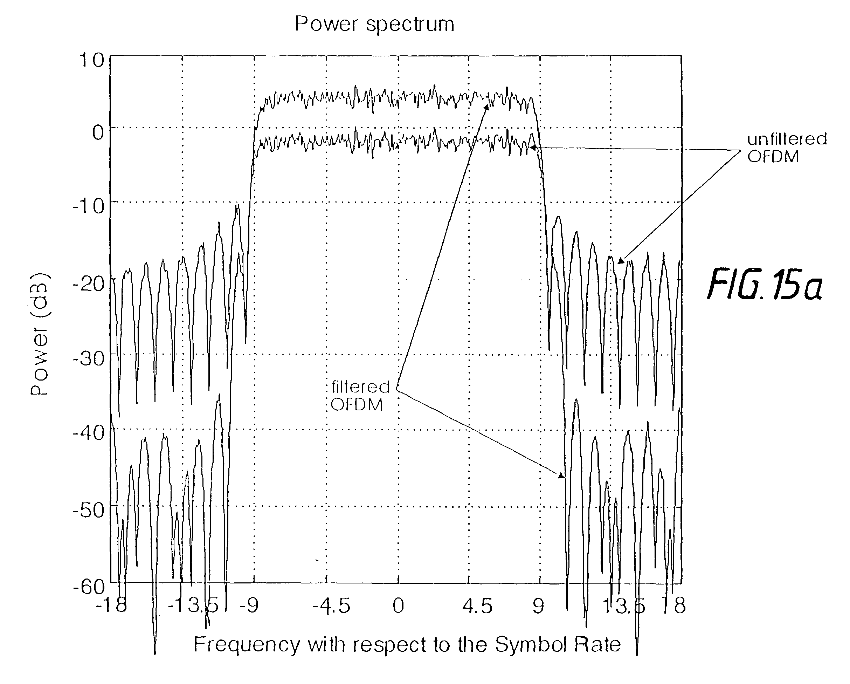

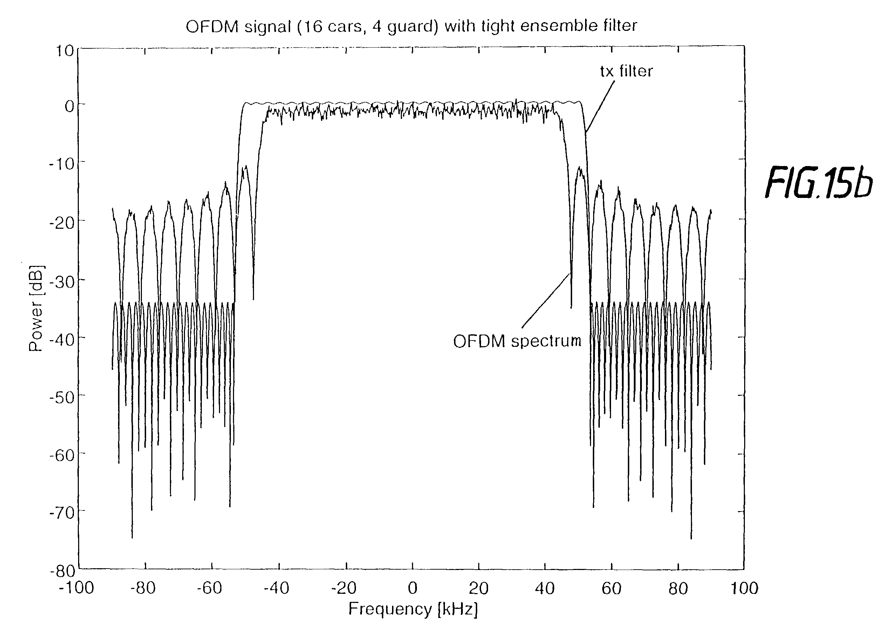

In this embodiment, the filter 135 attenuates the signal power to a level 35db below its peak, 10 kHz out from each edge subcarrier. Frequency domain plots showing the power spectrum of the multiplex signal before and after the transmit filter 135 are shown in Figure 15. The coefficients of the transmit filter 135 in this embodiment were derived to meet these constraints, together with the constraints that the amount of ripple in the pass band is less than 0.1db, and that the maximum or average power producible in the stop band (i.e. more than 10kHz from the edge subcarrier of the multiplexed signal) is minimised.

The filter is derived so that its zeros fall between the zeroes within the multiplexed signal (i.e. the zeroes of the filter fall on the sidelobes of the multiplex signal outside the first sidelobe), so as to make use of the attenuation provided by the zeroes of the multiplexed signal. An idealised filter response for the transmit filter 135 for 16 subcarriers is shown in Figure 15b.

Thus, the transmit filter employed for each ensemble size (or, more accurately, each number of subcarriers) is different. Accordingly, the transmit filter 135 further comprises a coefficient store, storing a set of filter coefficients for each ensemble size, the required coefficients being selected and loaded into the FIR filter by the ensemble management circuit 160.

After filtering, some slight distortion will have been introduced due to the elimination of the second and higher sidelobes, but this is not generally significant. The cut off of the filter is positioned in the middle of the first sidelobe, and consequently the outer part of the first sidelobe is attenuated, resulting in a narrowing of the first sidelobe.

To further reduce the peak-to-mean ratio, the filtered signal is processed by a peak clipping circuit 136 operating on samples of the OFDM symbol.

The magnitude of any signal sample above 7.8db (the average sample level being 0db) is truncated to 7.8db (which is preferably slightly higher than the threshold used in the peak to mean circuit 132). This does introduce some distortion, and hence a growth in the out of band power spectral density, and a reduction in orthogonality, but it is found that affects no more than around 0.3% of samples (10% of symbols).

The complex samples then pass to a pair of digital to analogue converters 137a,137b operating at 160 kHz, the analogue outputs of which are filtered by a pair of analogue smoothing filters 138a,138b to attenuate the aliased spectra due to the sampled signal stream. Preferably the smoothing filters 138a,138b have a linear phase characteristic, since the orthogonal frequency divisional multiplex technique is sensitive to delay distortion. The smoothed analogue signals are then supplied to the in- phase and quadrature input ports of a complex up converter 140 which modulates them onto an RF carrier frequency, and the modulated carrier frequency is supplied to the uplink antenna 101 for broadcast to the satellite 200.

In the foregoing, the action of the IFFT is simply to perform sinc pulse filtering process, applying a rectangular time window and generating (sin x)/x subcarriers. Naturally, a bank of filters could be employed instead of the IFFT device 131, if so desired.

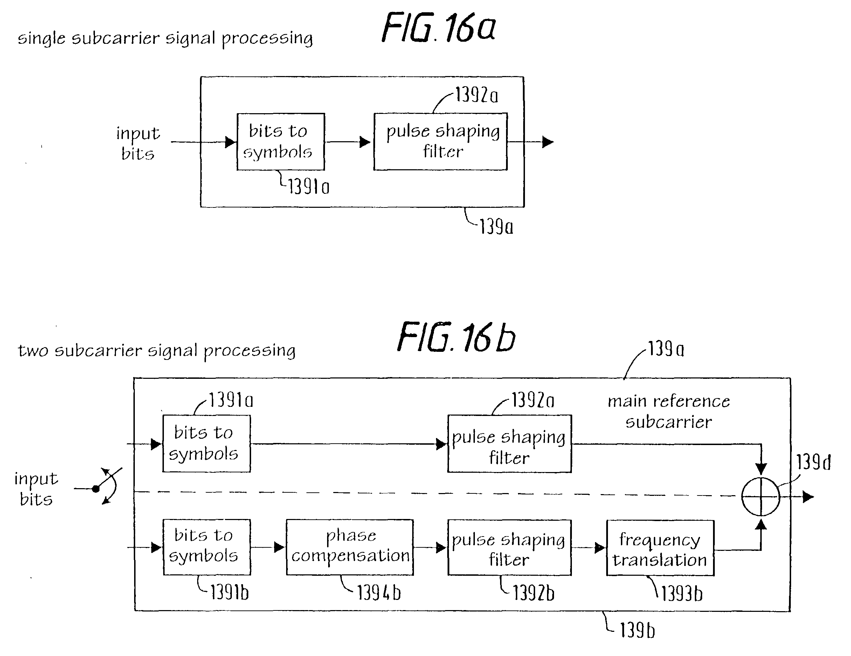

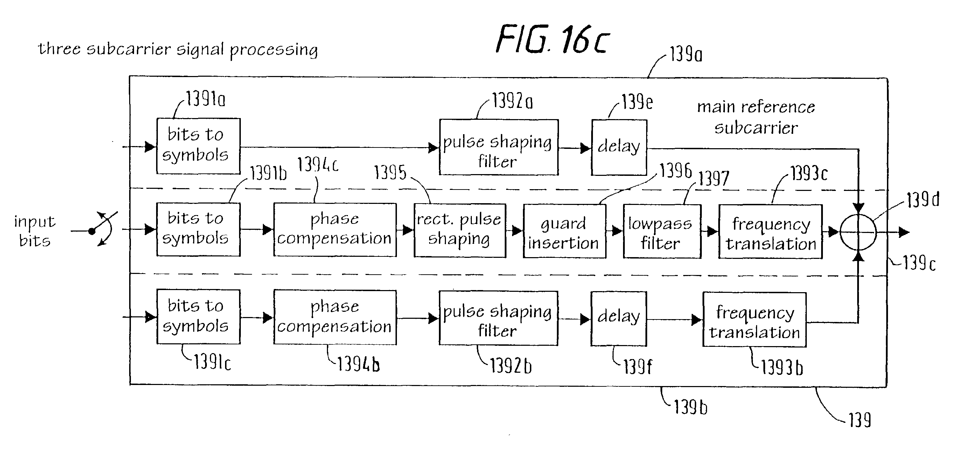

Referring to Figure 16, in the special case of very small numbers of subcarriers, the baseband elements 131-135 are replaced by pulse shaping filters which apply non-rectangular pulse shaping, in order to improve the spectral efficiency of the transmitted signal. This need not require any alteration to the receiver.

Accordingly, a non-rectangular filter/modulator device 139 is provided, connected between the components 131-136 of Figure 14 and in parallel therewith, and selected instead of those components when signals consisting of one, two or three subcarriers are to be transmitted.

The filter/modulator 139 comprises three paths; a main reference subcarrier path 139a; a first subcarrier path 139b; and a second subcarrier path 139c, the outputs of which are summed at a complex adder 139d. Selectable delays 139e,139f are selectable within the paths, respectively, of the channel circuits 139a and 139b.

The main reference subcarrier is, in this embodiment, to be positioned at 0Hz. Accordingly as shown in Figure 16a, the main reference subcarrier circuit 139a merely comprises a bit-to-symbol combining element 1391a, grouping two bits together to form a symbol of 36 successive samples. The sample stream is fed to a pulse shaping filter 1392a, which has an impulse response arranged to concentrate the energy of the pulse into the 32 signal samples and away from the four guard samples (which are not explicitly inserted). The filter may comprise an 81 tap FIR filter, for example. By controlling the impulse response of the filter to concentrate energy in the signal period and away from the guard period, and to generate lower sidelobes than the essentially rectangular IFFT filter, more efficient use can be made of the available RF spectrum.

As shown in Figure 16a, where only a single subcarrier (the main reference subcarrier) is transmitted, only the circuit 139a is switched into operation, and operates as discussed above.

Referring to Figure 16b where two subcarriers are employed, the input bits are switched between the circuit 139a and the first subcarrier circuit 139b. This circuit represents an edge subcarrier spaced from the main reference carrier by $\Delta$ (i.e. 5kHz). Accordingly, in addition to the bit- to-symbol converter 1391b (operating in the same manner as the bit to symbol converter 1391a above) and pulse shaping filter 1392b (for performing the same purpose as the filter 1392a), there is provided a frequency translator circuit 1393b, which up- converts the samples from the pulse shaping filter 1392b by 5kHz.

In the circuit 139b, the pulse shaping filter 1392b therefore likewise shapes the input sample stream so as to tend to form a guard band of four samples, which, at the receiver (as will be discussed below), are deleted. However, because frequency translation of this subcarrier occurs after the guard band has effectively been inserted by the pulse shaping filter 1392b, deletion of the guard band at the receiver would result in a phase jump, corresponding to $4/32=\frac{1}{8}$ of a circle, or $\pi/4$ radians.

Accordingly, a phase compensation circuit 1394b is provided prior to the pulse shaping filter 1392b, to rotate the phase of each successive symbol by an additional $\pi/4$ radians, prior to pulse shaping in the pulse shaping filter 1392b. In other words, the phase compensation applied by the phase compensation circuit 1394b increases, on each successive symbol by an increment of $\pi/4$. The amount of phase compensation is variable depending on the number of subcarriers as is the frequency translation, as are the filter parameters.

Thus, referring to Figure 16b, where only two subcarriers are present, the two streams of samples generated by the two circuits 139a and 139b are added by the adder 139d, to produce a complex output stream, for up-conversion. In this case, the coefficients of the filter 1392a are replaced with different values to those used when a single subcarrier is present.

Referring to Figure 16c, where three subcarriers are employed, the frequency translation circuit 1393b applies a $2\Delta$ (i.e. 10kHz) frequency translation, and the phase compensation circuit 1394b applies a $\pi/2$ phase increment at each successive symbol.

The operation of the main reference subcarrier circuit 139a is substantially as before. The centre subcarrier at 5kHz is processed by the second subcarrier circuit 139c, which comprises a bit to symbol converter 1391b generating a sample stream; a phase compensation circuit 1394c applying a $\pi/4$ incremental phase rotation on each successive symbol; and a frequency translation circuit 1393c applying a (x8/9) = 4.44kHz frequency translation.

However, rather than applying a non-rectangular pulse shaping filter 1392 as above, in this case, since the subcarrier lies in between the two edge subcarriers, it is acceptable to allow the first sidelobes to pass unsuppressed, since these overlap the neighbouring edge subcarriers. Accordingly, a rectangular pulse shaping filter 1395 is used to filter the phase compensated sample stream, and a guard band insertion circuit 1396 inserts 4 zero valued sample periods as a guard band. A lowpass filter 1397 applies a roll off to the second and subsequent sidelobes prior to frequency translator 1393c. It would, in fact, be possible for the rectangular pulse shaping filter, guard insertion circuit 1396, and lowpass filter 1397 all to be provided by the same digital signal processor (DSP) device.

The delays 139e,139f within the reference subcarrier circuit 139a and first subcarrier circuit 139b are switched in, to compensate the delays in the second subcarrier circuit 139c arising from the lowpass filter.

The values of the coefficients of the filters 1392a are, again, different in this case to the one-or two-subcarrier cases.

In the case where two or three subcarriers are present, the spectral response of the pulse shaping filters 1392a,1392b may be made asymmetrical. This is because the two subcarriers (where only two are present) or the outer two subcarriers (where three are present) are edge subcarriers, each having another subcarrier on one side. The pulse shaping filters for the edge subcarriers therefore may have asymmetrical spectral responses, attenuating the subcarrier spectrum on the outer side of the centre frequency of the edge subcarrier more than on the inner side. Since the spectral responses of the pulse shaping filters are asymmetrical, the filters are required to be complex.

In general, suitable pulse shaping filters may be based on, for example, raised cosine filters of 50% roll off, modified using a design tool such as the Optimisation Toolbox of Matlab (TM).

Thus, by employing pulse shaping filters for the edge subcarriers for a multiplexed signal consisting of one or a small number of subcarriers, it is possible to drastically improve the spectral efficiency of the modulation process, without necessarily requiring any alteration to the receiver.

Receiver

One example of a receiver 300 of the system of Figure 1 will now be described.

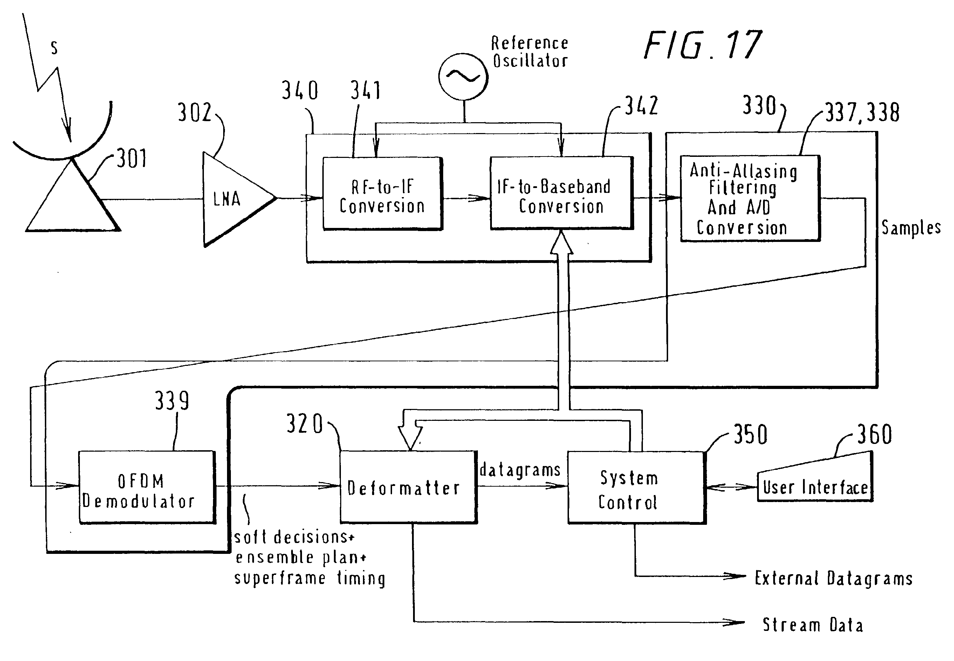

Referring to Figure 17, the broadcast multiplex signal S is received by the receiver antenna 301 (which may be an omnidirectional antenna) and amplified by a low noise amplifier 302, both of conventional design. An RF down conversion circuit 340, comprising an RF to intermediate frequency (IF) conversion stage 341 and a controllable IF to baseband conversion circuit 342, convert the RF signal to a baseband signal which is supplied to a baseband processing circuit 330 comprising anti alias filtering and digitising circuits 337,338, and a frequency demultiplexer demodulator circuit 339.

The stream of demodulated samples from the baseband processing circuit 330 is deformatted into channels by a deformatter circuit 320, and the output channels are either supplied to an audio decoder/reproduction circuit, or to other data utilising apparatus (e.g. a computer or a facsimile machine). The ensemble plan, beam plan, station plan, service plan and other control data is supplied from the deformatter 320 to a system control circuit 350 (e.g. a microprocessor), which controls the operation of the IF to baseband conversion circuit 342 and deformatter 320, supplies output display data to a user interface 360 and receives input commands therefrom.

The operation of the components of Figure 17 will now be discussed in greater detail.

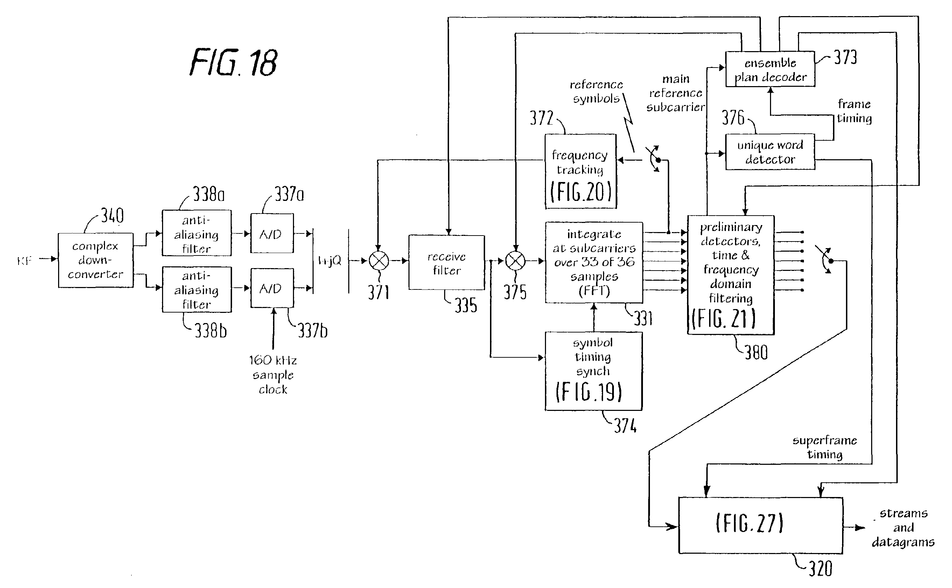

Referring to Figure 18, the baseband signal from the down converter 340 comprises real and imaginary components, each of which passes to a respective anti aliasing filter 338a,338b and digital to analogue converter 337a, 337b, the latter being driven at a sampling rate of 160 kHz. The stringency required of the anti aliasing filters 338a, 338b may be relaxed by employing over sampling and noise shaping sigma-delta digital converters 337. For example the DSP 56 ADC 16 bit sigma-delta analogue to digital converter (available from Motorola Incorporated) may be employed.

The digital real and imaginary components are then supplied to a complex multiplier 371, where they are multiplied by a frequency signal from a frequency tracking circuit 372, tracking the offset frequency of the main reference subcarrier, to bring the main reference carrier component of the baseband signal to the centre of the bandwidth of a receiver filter 335 having a bandwidth controlled from an ensemble plan decoder circuit 373, in dependence upon the number of subcarriers decoded as being present in the multiplexed signal.

A timing detector circuit 374 extracts the position in time of the guard samples, and hence the start and finish of each symbol period.

The filter samples are then down converted so that the main reference carrier lies at 0 Hz at a complex multiplier 375.

Next, the signal level and phase on each of the subcarriers over the symbol period is extracted by a Fast Fourier Transform circuit 331 (a commercially available IC, or a DSP device), integrating over 33 samples of the whole 36 samples-plus-guard-time symbol repetition period, as shown in Figure 7, the timing of the samples being controlled by the timing extraction circuit 374.

The signal on the main reference subcarrier is supplied to the frequency tracking circuit 372, and all the subcarrier signals are supplied to a detector and filter circuit 380, the filtered outputs of which are time multiplexed together in a round robin fashion and supplied to the deinterleaver circuit 320.

The main reference subcarrier signal, filtered by the detector filter circuit 380, is supplied to the ensemble plan decoder circuit 373, and to a unique word detector circuit 376 which, upon detection of the unique word or the inverse unique word in the stream of bits on the main reference subcarrier, triggers the ensemble plan decoder circuit 373 to decode the ensemble plan.

The timing from the unique word detector circuit 376 indicating the superframe start and finish points may be used to provide the timing for an audio codec if present in the receiver 300, where, as here, the superframe lengths are in direct proportion to the lengths of standard audio codec frames.

The receive filter 335 rejects out-of-band signals, and may simply have the same spectral response as the transmit filter 135 for each ensemble size (number of subcarriers). Accordingly, it comprises stored information defining a number of different filters, one for each ensemble size, selected in accordance with the ensemble size.

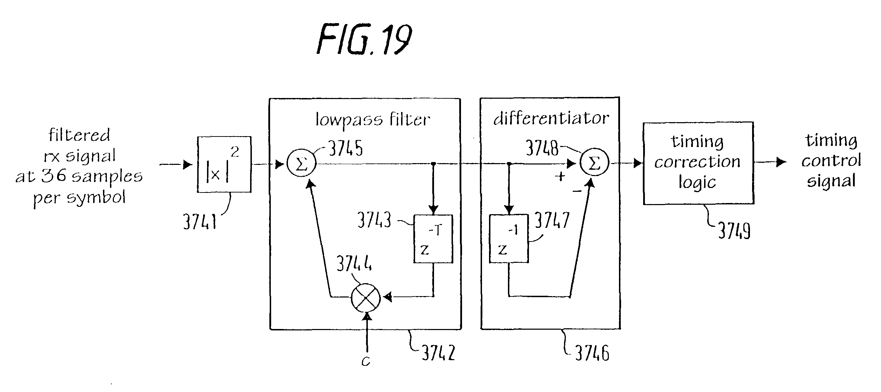

The symbol timing and synchronisation circuit 374 is shown in Figure 19 in greater detail. It comprises an amplitude extraction circuit 3741 which extracts the magnitude (squared) of the complex signal, sample by sample, as the sum of the squares of the real and imaginary parts; a lowpass comb filter circuit 3742 comprising a T-stage feedback delay 3743 (where T is the number of samples per composite symbol period; in this case 36), feeding back signal magnitude samples, through a multiplier 3744 applying a scalar multiplication of close to unity (e.g. c=0.9999), to an adder 3745 where the feedback samples are added to the incoming samples.

The action of this circuit is therefore to perform long time scale averaging of each sample with its predecessor samples in the same sample position in preceding symbol periods. Since the symbols can have varying values, the sample magnitudes in all the 32 sample periods during which symbol information is present each average out to some constant level corresponding to the average signal plus noise magnitude. On the other hand, the four guard sample periods over which only noise is present have a long term average value corresponding to the average noise power. Thus, after long term filtering by the lowpass filter 3742, the four guard samples are easily detected within the 36 samples making up each composite symbol period.

To find the sharp edges defining the beginning and end of the four guard sample period, the lowpass filtered signal is fed to a difference circuit 3746 comprising a feed forward one sample delay 3747, the output of which is subtracted from the filtered signal at a subtraction node 3748. Thus, a sharp bipolar pulse is produced for each guard interval, with a negative going pulse at the beginning of the guard interval and a positive going pulse at the end of the guard interval. A logic circuit 3749 notes the positions in the sample stream of the positive going and negative going pulses, and compares these with predicted positions based on timing of previous pulses, and, where necessary, advances or retards the signal start and end timing.

Thus, it will be seen that in this embodiment, the use of a guard period with a predetermined amplitude different to the average amplitude of the signal (e.g. a zero amplitude), enables the symbol period timing to be extracted by the receiver by detecting the signal envelope, without requiring the signal frequency to be exactly acquired. This independent acquisition of the symbol timing is of considerable value in the signal acquisition process of the receiver according to this embodiment.

Furthermore, by utilising relatively long term (i.e. long time constant) lowpass comb filtering or averaging, processing each sample with its predecessors at the same position within preceding symbol periods, it is possible to operate in extremely high noise environments; for example, in tests, at 0 db, over one million symbols, the standard deviation of the detected position of the start of the symbol was only 0.0025 of a symbol period.

For receivers intended to operate with the above described transmitter in which, for small ensembles consisting of only a few subcarriers, guard bands are not explicitly inserted, it is preferred to have an additional timing detector (since in this case the transition between the beginning and end of the symbol periods of 32 samples may not be sufficiently sharp for the differentiator to produce clear peaks). For example, rather than employing differencing following the lowpass filter, a 36 sample window could be employed, with taps from each cell of the window, and the 32-sample contiguous block yielding the highest energy (i.e. the highest sum of squared sample magnitudes) could be found and used to correspond to the symbol period.

Conveniently, the magnitude extracting circuit 3741, lowpass filter 3742, differencer 3746 and timing logic 3749 are all implemented by a single digital signal processor (DSP) device performing corresponding processing routines.

For most normal transmission channels the timing logic 3749 needs merely signal to commence the symbol period on the positive timing pulse and stop the symbol period on the negative timing pulse. In the presence of strong time dispersion, however, impulses may shift apart as the symbol is stretched by the dispersion, leading to extension of the length of each symbol period. The timing logic 3749 in this case therefore adjusts the length of the symbol period accordingly.

The symbol start and end signals from the timing synchronisation circuit 374 are used to control the integration period of the demodulator 331. Where the demodulator 331 is a Fourier Transform circuit, the start and end signals are used to order the sequence of the samples so as to start the integration on the correct sample. Where the demodulator 331 is a bank of integrate and dump filters, the start and end signals are used to start and end the integration (or, more accurately, summing) periods of the filters.

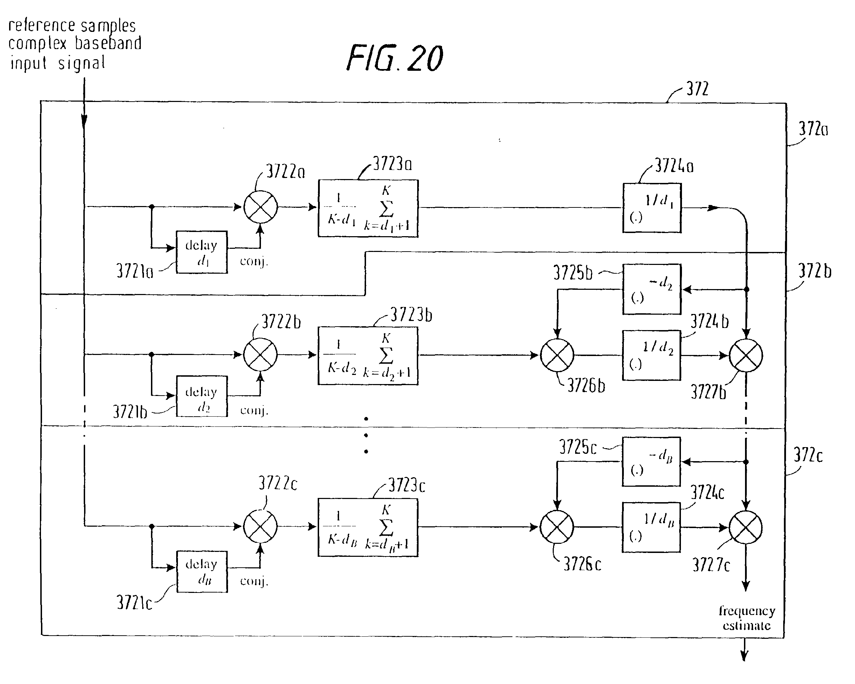

Referring to Figure 20, the frequency tracking circuit will now be described in greater detail. The frequency tracking circuit utilises the delay-multiply-average (DMA) technique described in "Performance of a simple delay-multiply-average technique for frequency estimation", S. Crozier, K. Moreland; Canadian Conference on Elect. and Conf. Engineering (CCECE '92), Toronto, September 13-16, 1992; and "Implementation of a simply-delay-multiply-average technique for frequency estimation on a fixed point DSP", R. Young, S. Crozier; Personal Indoor and Mobile Radio Communication Conf. (PIMRC) Oct 19-21, 1992, pages 59-63. The technique will briefly be described here.

Referring to Figure 20, the frequency tracking circuit 372 comprises a plurality of cascaded delay-multiply-average branches 372a,372b,372c. The structure of each branch is essentially the same; it consists of a delay 3721 on a feed forward path from the input; a complex conjugator device taking the complex conjugate of the delayed signal (not explicitly shown), a complex multiplier 3722 multiplying the conjugate of the delay signal by the input signal; an integrator 3723 calculating an average of the output of the multiplier 3722; and a rooting circuit 3724 extracting the d'th complex root of the average (where d is the length of the delay 3721 in sample durations).

The operation of each delay-multiple-average circuit 372 is as follows. The effect of the multiplication (multiplier 3722) by the conjugate of the delayed signal is to extract the phase change between the input signal and the delayed signal (i.e. the input signal d samples ago). If the input signal is in the same phase as the signal d samples ago, the phase difference is zero. If not, then the non-zero value represents the rate of change of phase with respect to time, and hence the frequency error.

The integrator 3723 averages, over K (e.g. 100) samples, the phase change (or frequency) phasor. The root circuit 3724 extracts the value per sample delay period of the phasor shift.

The delays in the branches 372a,372b,372c progressively increase in this embodiment. It is found that the length of the delay affects the result in two different ways. Firstly, increasing the length of the delay increases the accuracy with which the phase change is measured. This is because the phase change per sample is effectively averaged over the delay period, so that the accuracy of the phase change measured is proportional to the length of the delay.

Secondly, the bandwidth within which the frequency tracking is effective is inversely proportion to the length of the delay. For a delay of length one sample, the bandwidth is +/- 0.5 times the sample repetition frequency. However, as the delay length increases, the possibility of aliasing effects likewise increases; in other words, the possibility that the phase may change by more than $2\pi$ radians within the delay length is raised. For longer delays there is thus an ambiguity as to whether the phase change per d samples is $\Delta$, $2\pi + \Delta$, ... $2N\pi + \Delta$. The frequency is thus ambiguous, in multiples of the symbol repetition frequency.

In this embodiment the delay $d_1$ in the first DMA circuit 372a is one sample, so that the output of the circuit 372a is unambiguous provided that the frequency offset is within a range of one reference symbol repetition period (i. e. 1.125ms). However, the output is noisy due to the noise on the channel.

The second DMA circuit 372b has a delay, in this embodiment, equal to four samples. The output of the averager 3723b, represents the amount of phase shift in four samples, and is considerably more accurate (i.e. less affected by noise on the channel), but only over 1/4 of the bandwidth, and hence the phasor may either represent the phase shift, or the phase shift plus $2\pi N$ radians (where N is an integer).

This phasor is therefore not directly used, but instead is used to correct the output of the first DMA circuit 372a. To achieve this, the output of the first DMA circuit 372a is fed to an exponentiation circuit 3725b, which raises it to the power $-d_2$, where $d_2$ is the delay of the second DMA circuit (in this case 4), and the result is multiplied by the output of the averager 3723b by a multiplier circuit 3726b.

Thus, the effect of the two circuits 3725b,3726b is to raise the existing frequency estimate to the power $d_2$, which effectively rotates it in the complex plane by an amount equal to that by which the output of the averager 3723b is rotated due to the delay $d_2$, and then to divide the output of the averager 3723b by the thus-rotated existing frequency estimate.

The result therefore has a phase which is the phase difference, over $d_2$ samples, of the initial frequency estimate from the DMA circuit 372a and the estimate generated by the second DMA circuit 372b. This difference is then added to the initial frequency estimate of the first DMA circuit by multiplying the two together at multiplier 3727b, after extracting the $d_2$'th root of the output of the multiplier 3726b in the rooting circuit 3724b, so as to reduce the answer to a phase shift per sample (rather than per four samples).

This process may alternatively be viewed as using the initial phase estimate from the first circuit 372a to select the correct root of the phasor generated by the second DMA circuit 372b.

In exactly the same way (which will not be further described), a third DMA circuit 372c with a delay of 16 samples produces a third, still more precise, phasor which is used to correct the output from the second circuit 372b so as to further improve the accuracy thereof.

It will be apparent that, in fact, yet further circuits 372 could be provided to give yet higher accuracies.

The number of samples K providing the window over which averaging is performed is, in this embodiment, 100. It is necessary for the number of samples K to be significantly greater than the longest delay (in this case, 16 samples) present in the frequency tracking circuit 372, but since the size of the window K dictates the rapidity with which frequency is tracked, it should not be excessively long.

The output of the third DMA circuit 372c, taken from the multiplier 3727c, is a phasor the phase of which is proportional to the frequency offset between the received signal and its correct value, if (as in this embodiment) the phase of each reference symbol is the same as the predecessors.

Thus, the circuit of Figure 20 achieves frequency tracking with a frequency range dictated by the broadest range of the three branches 372a-372c, and an accuracy dictated by the most accurate of the three branches.

It is also possible, as mentioned in the above disclosed references, to raise the incoming signal to a higher power than unity prior to each DMA circuit 372; in this case, the exponents applied in the circuits 3724 and 3725 correspond to the products of the delay and the power, rather than merely the delay as in Figure 20.

The frequency tracking circuit 372 is, in this embodiment, provided by a digital signal processor (DSP) device, performing each of the operations shown separately as hardware elements in Figure 20. This is readily achieved using current digital hardware, because, firstly, the reference symbol rate is relatively low and hence the necessary sample rate is only 888 Hz; and secondly, the frequency estimate is only required ten times each second and the only operations therefore required at this sampling rate are the delay, multiply and averaging operations for each of the three branches; the exponentiation operation is only required once every one hundred milliseconds.

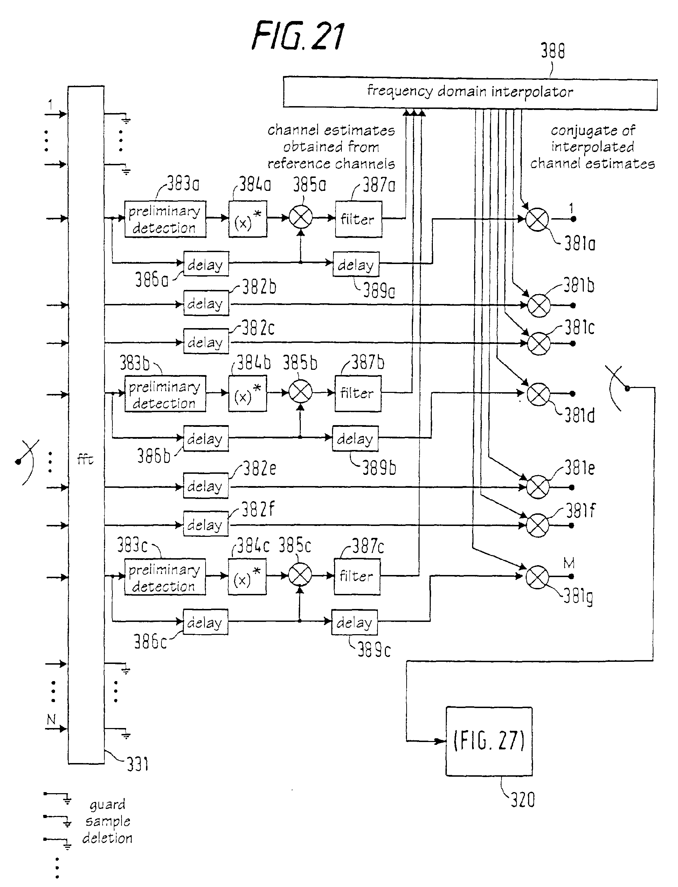

Referring to Figure 21, the baseband demodulation and filtering will now be described.

The bank of (1 to 32) subcarrier estimates output by the demodulator 331 for each subcarrier in each symbol period are each multiplied by the conjugate of an estimate of the channel on each subcarrier, by a bank of corresponding complex multipliers 381a,381b...381g (32 in all). This has the effects of:

(1) removing phase errors due to the phase of the channel; and
(2) weighting each subcarrier sample by the magnitude of the channel (so as to give less emphasis to signals received on weak channels).

The reference subcarriers are extracted to derive the reference information which was inserted into the multiplexed signal at the transmitter, to derive the channel estimates as described in greater detail below. The non reference subcarriers are simply delayed by delays 382b,c,e,f as shown, these delays corresponding to the delay imposed by the extraction of the reference information on the reference subcarriers.

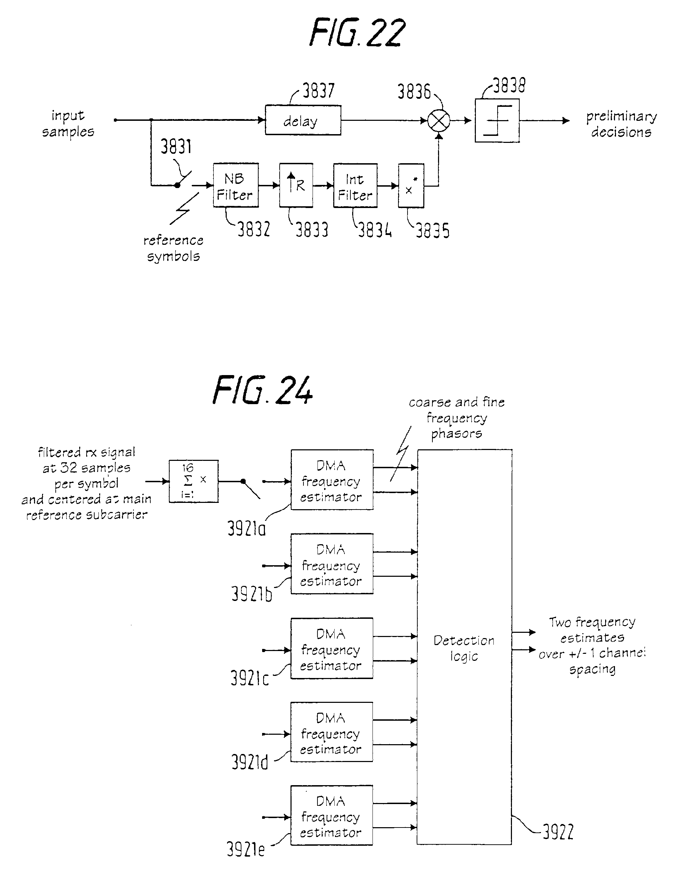

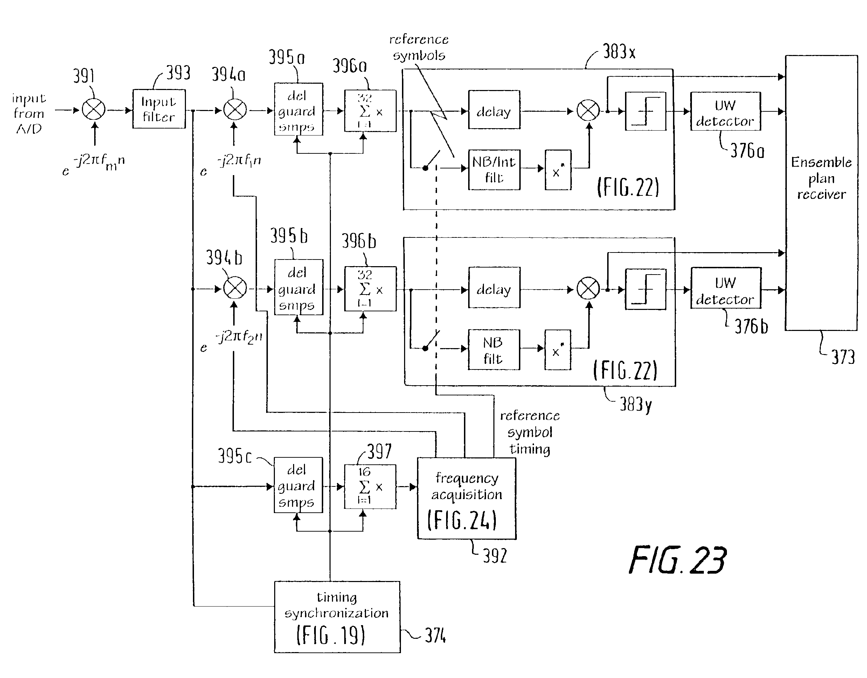

As shown, on each reference subcarrier, there is provided a preliminary detection circuit 383. The preliminary detection circuit 383 outputs, after each sample period, a sample having one of the two or four possible phase values (depending upon whether the subcarrier is carrying one or two channels). The structure of the preliminary detector will be discussed below in greater detail with reference to Figure 22.

Following each preliminary detector 383 is a complex conjugate circuit 384a-384c, the outputs of each of which are fed to a respective complex multiplier circuit 385a-385c. The subcarrier is fed through a delay stage 386a, 386b,386c (of length corresponding to the delay imposed by the preliminary detector circuits 383a,383b,383c).

Thus, in each symbol period, the symbol actually received is multiplied by the conjugate of the symbol which should be present (if the preliminary detector 383 has correctly performed detection). If the channel has imposed no phase shift on the transmitted symbol, the two will be in phase, and hence the output of the multiplier will have a phase angle of zero. If the channel has, on the other hand, imposed a phase shift on the transmitted symbol then the output of the multiplier 385 will have a phase corresponding to that imposed by the channel on the transmitted symbol.

These channel phase samples are fed to lowpass filters 387a-387c, each of which passes the (fading) carrier samples and rejects noise lying outside the band occupied by the faded subcarrier. Each filter 387 may simply be a FIR filter with a length of 41 taps, with tap weights designed to pass the frequency band of the subcarrier and exclude out-of-band noise.

The temporally filtered phase samples from each subcarrier are then supplied from the temporal filters 387 to a frequency domain interpolator 388 which calculates, in each sample period, the intervening subcarrier phase samples between the reference subcarrier phase samples. In this embodiment, the frequency interpolator 388 simply performs linear interpolation; thus, each interpolated channel estimate sample comprises a linear superposition of the neighbouring (in frequency) temporally filtered reference subcarrier channel estimate samples.

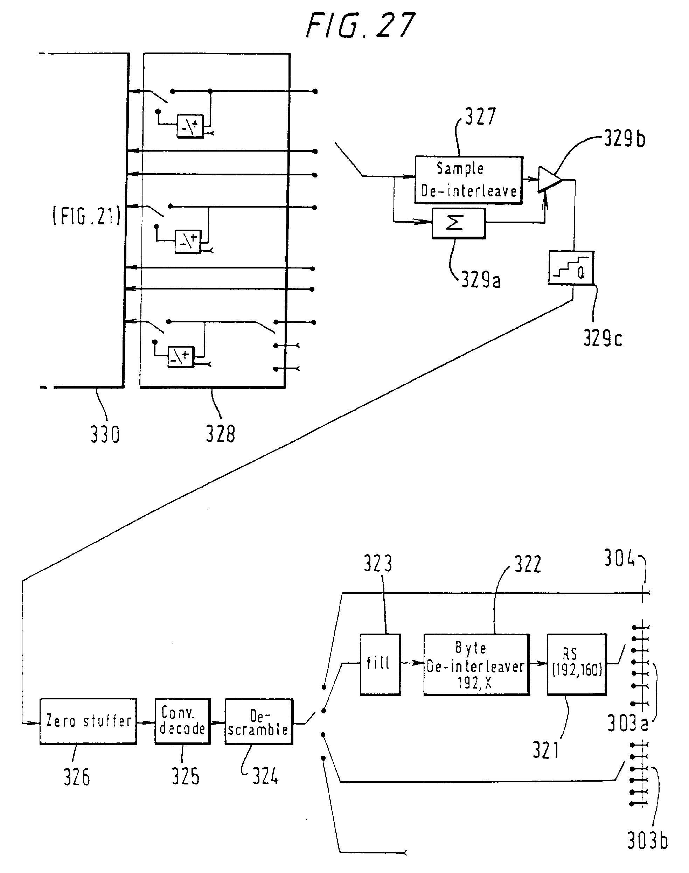

The output of the frequency domain interpolator circuit 388 is thus a carrier phase sample for each subcarrier, and the conjugates of these phase samples (generated by conjugation circuits (not shown)) are multiplied by the samples on each subcarrier at the multipliers 381a-381g. To time align the reference subcarriers, they are fed through further delays 389a-389c corresponding to the delay imposed by the temporal interpolation filters 387a-387c and frequency domain interpolator 388. The outputs of the multipliers 381 are therefore corrected for channel phase, and are sampled in turn and fed to the deformatter circuit 320 (described in greater detail with reference to Figure 27).

Referring to Figure 22, each preliminary detector 383 comprises a reference symbol sub-sampling circuit (shown schematically as a switch) 3831, which closes once every five samples to pass a reference sample; and a narrow band filter 3832 comprising a lowpass filter with a stop band above around 250Hz (wide enough to pass any residual error frequency, and the maximum fading frequency). The reference symbols are then up-sampled to the data symbol rate (i.e. by a factor of five) by an up-sampler circuit 3833 repeating each reference symbol five times. Time domain smoothing is performed by an interpolating filter 3834, and the conjugate of each reference sample is taken by a conjugating circuit 3835, the output of which is fed to a multiplier 3836 which receives each input sub carrier sample via a delay 3837, the delay 3837 corresponding in length to the delay of the components 3832-3835.

Thus, the preliminary detectors act as simple coherent demodulators, multiplying the subcarrier by the conjugate of the reference information to produce a sequence of symbols corrected for the phase error due to the channel. These corrected symbol samples are fed to a hard decision circuit 3838 comprising a phase discriminating circuit which detects which of the four possible symbol phases (for a subcarrier carrying to channels) or two possible symbol phases (for a subcarrier carrying one channel) the corrected sample lies closest to, and outputs that phase value as a preliminary decision sample.

Since the reference information is carried over two successive sample periods, there is also provided (not shown) an adder circuit and one sample delay, to add together every fourth and fifth sample to reconstitute the reference symbol on each reference subcarrier (other than the main reference subcarrier).

In order to commence reception, the receiver needs to discover how many channels are present in the frequency multiplexed signal. This information is, in this embodiment, carried on the main reference subcarrier, and in order to decode it the receiver needs to acquire accurately the frequency of the main reference subcarrier, which will vary due to the Doppler effect where the receiver is in a mobile station (e.g. a car or an aeroplane) or where the signal is relayed via a non geostationary satellite 200. Accordingly, the receiver has a signal acquisition phase in which it acquires the frequency of the main reference subcarrier, and then extracts the frame and super-frame timing and thereby decodes the number of channels present in the multiplexed signal S. For this purpose, the receiver includes an acquisition circuit 390, shown in Figure 23.

Referring briefly to Figure 23, the acquisition circuit 390 comprises an RF down converter 391 followed by a filter 393 centred on the frequency employed on the transmitter for the main reference subcarrier, and having a bandwidth of 18kHz; 10kHz for the main lobe of the reference subcarrier and plus/minus 4kHz (80% of the channel spacing).

The acquisition circuit 390 comprises the timing synchronisation circuit 374 shown in Figure 19, which can extract the sample timing without needing frequency synchronisation. It comprises also a frequency acquisition circuit 392 which requires the frequency of the main reference subcarrier as will be described in greater detail below. In fact, two putative subcarrier frequencies are extracted, and one is supplied to each of two multipliers 394a,394b acting as down converters on the filtered input signal. On each of the two down converted frequencies, the signal is fed (after deletion of guard samples in guard sample deletion circuits 395a,395b, and integration over a symbol period in integrators 396a,396b), to respective preliminary decision circuits 383x,383y, each of the types shown in Figure 22. The stream of symbol samples on each frequency are then fed to a unique word detector circuit 376a or 376b comprising a coincidence register comparing the stored frames synchronising unique word with the contents of the window of symbol samples passing through a shift register.

When either one of the unique word detectors 376 detects the new unique word, the frequency with which the signal fed to the unique word detector was demodulated is selected as the main reference subcarrier frequency, and the succeeding symbols on the main reference subcarrier at that frequency are decoded by the ensemble plan receiver 373, to detect how many channels are present on the ensemble signal and thereafter set the bandwidth of the filter 335 to enable reception as described above.

Referring to Figure 24, the frequency acquisition circuit 392 is shown in greater detail. Samples from the receive filter 393 pass to a circuit 395c which deletes the guard samples under control of the timing synchronisation circuit 374 of Figure 19, and the resulting samples are integrated into half symbol periods (i.e. sixteen successive channel samples are integrated). The pairs of half symbols in each symbol period (synchronised by the timing synchronisation circuit 374) are distributed in round robin fashion between five frequency estimator circuit 3921a-3921e. Thus, one of the five frequency estimators 3921 will receive the reference symbols, and will hence (where, as in this embodiment, the reference symbols all have the same phase) have successive samples all in the same phase when the correct frequency is acquired. The other four frequency estimators will receive data symbols, which will therefore be of varying phases. The rate of operation of the frequency estimators is 2 half symbol samples every 5 symbol periods; i.e. 2/5 the symbol rate.

Each frequency estimator 3921 supplies an estimated frequency to a decision logic circuit 3922, which decides which of the five frequency estimator circuits 3921 is receiving the reference symbols, and uses the outputs thereof to generate, in this embodiment, two putative subcarrier frequency estimates which are supplied respectively to the two multipliers 394a,394b.

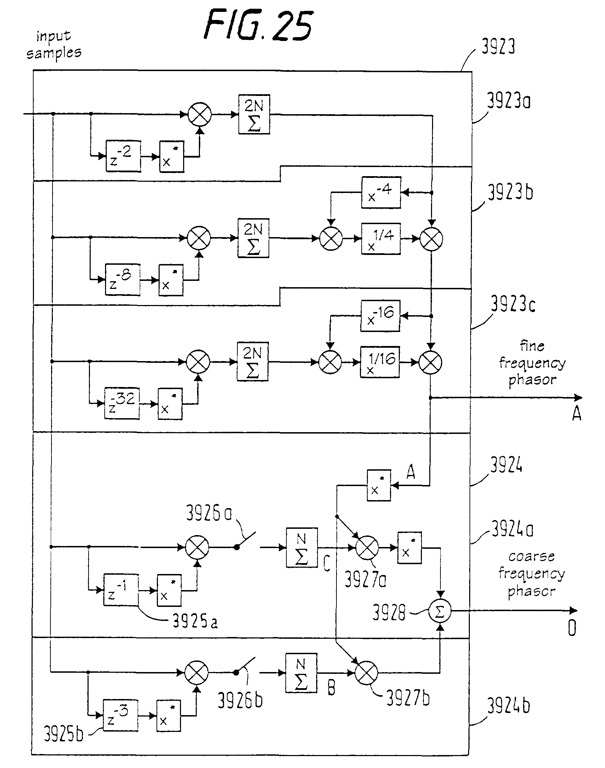

The operation of each frequency estimator 3921 will now be described in greater detail with reference to Figure 25. The frequency estimator comprises a fine frequency estimator 3923 comprising three branches 392a,392b, 392c, which are equivalent to the branches 372a,372b,372c of Figure 20 except that the delay in each branch is twice as many stages, since the input samples each represent only half a symbol period. Thus, in the first branch 3923a, the phase difference between each half symbol sample and the half symbol sample one reference symbol period previously (5 symbol periods previously) is taken, whereas in the second branch the phase difference between each half symbol sample and the half symbol sample 4 reference symbol periods previously is taken, and in the third branch the phase difference between each half symbol sample and the half symbol sample 16 reference symbol periods previously is taken.

As described above with reference to Figure 20, the output of the fine frequency estimator 3923 is a frequency phasor which is accurate, but ambiguous by a frequency equal to the reference symbol rate (i.e. 888 Hz). In this embodiment, the averaging in each of the three sections 3923a-c is over 200 half symbol sample periods (100 reference symbol periods, 500 symbol periods). The output of this fine frequency estimator is employed by the detection logic 3922 to detect which of the frequency estimators 3921a,3921e is receiving the reference symbols; since the symbols on the other frequency estimators 3921 are of arbitrary phase, the magnitude of the output of the fine frequency estimator 3932 which carries the reference symbols will be significantly higher than the magnitude of the output of the other frequency estimators, and its phase will be almost constant over time whereas the outputs of the other frequency estimators will exhibit a random phase behaviour.

To resolve the frequency ambiguity in the fine frequency estimate generated by the fine frequency estimator 3923, a coarse frequency estimator 3924 is provided, comprising two branches 3924a and 3924b. In the first branch, a one sample delay 3925a is provided. Thus, in the first branch 3924a, the phase difference between the first half of one reference symbol and the second half of the reference symbol which preceded it (five symbol periods ago) is taken, followed by the phase difference between the second half of the reference symbol and the first half of the same reference symbol, and so on, in alternation. A gate 3926a is provided to block every second phase difference, clocked so as to pass only those differences corresponding to the difference between the first half of one reference symbol and the second half of the symbol which preceded it. Thus, the first section 3924a produces a measure of the phase change over 4½ symbol periods.

In the second section 3924b, a three sample delay 3925b is provided which enables the extraction, on alternate samples, of the phase difference between the second half of one reference symbol period and the first half of the reference symbol period which preceded it (five symbol periods previously), and the first half of a reference symbol period and the second half of the reference symbol which preceded it nine symbol periods previously.

Again, a gate circuit 3926b passes only alternate samples, namely only those samples corresponding to the phase difference between the second half of a reference symbol period and the first half of the immediately preceding reference symbol (5½ symbol periods previously). Therefore, the second section 3924b generates a frequency phasor corresponding to the phase shift over 5½ symbol periods.

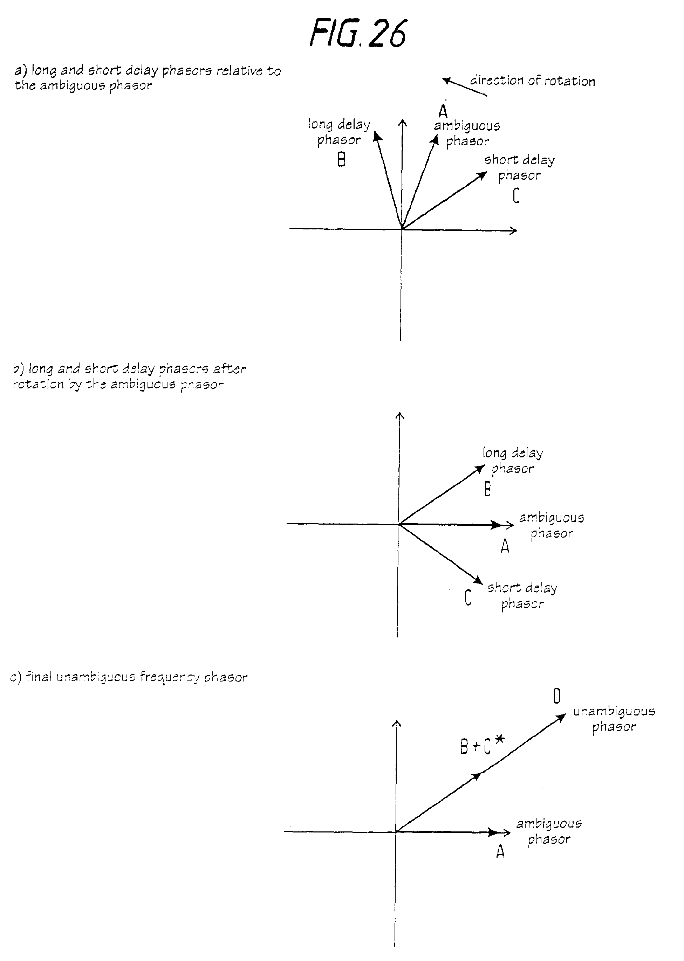

The output (A) of the fine frequency estimator 3923 is conjugated and the conjugate supplied to multipliers 3927a,3927b, so as to subtract the phase of the fine frequency phasor (A) from the output (C) of the short delay stage 3924a and the output (B) of the long delay stage 3924b. This has the effect of rotating each of these in the complex plane by the subtraction of the phase of the fine frequency phasor (A) , as shown in the transition from Figure 26a to Figure 26b.

Next, the output of the multiplier 3927a is conjugated and supplied to a complex adder 3928 receiving the output of the multiplier 3927b, so as to invert the phase angle of the phasor C and add it to the phasor B. The resulting phasor D is output as a coarse frequency estimate.

The operation of the coarse frequency estimator 3924 will now be explained in greater detail. The fine frequency estimate A is ambiguous in multiples of 888Hz (the reference symbol repetition rate). The outputs of the two stages 3924a,3924b of the coarse frequency estimator 3924 are liable to a similar level of ambiguity, since they measure phase changes in intervals of 4½ and 5½ symbol periods (as opposed to the fine frequency phasor, which measures phase changes every five symbol periods corresponding to one reference symbol repetition period).

However, the phase difference between the fine frequency estimate phasor A and the longer delayed phasor B corresponds to the phase change in half a symbol period (the difference between the phase change in 5 symbol periods and the phase change in 5½ symbol periods). Similarly, the phase difference between the fine frequency phasor A and the phasor C generated by the shorter delay branch 3924a corresponds to minus the phase change over half a symbol period (the difference between the phase change over 5 symbol periods and the phase change over 4½ symbol periods). In fact, the periods concerned are not exactly +/- ½ a symbol repetition period because of the 4 guard samples. Thus, by measuring either one of these phase differences, a frequency estimate which is accurate to about twice the reciprocal of the symbol repetition rate (i.e. 5kHz) can be obtained. The bandwidth of 5kHz, rather than 4.44kHz, is due to the presence of the guard samples. It will be clear from Figure 26 that the phasor D corresponds to this phase change over (approximately) half a symbol period and is unambiguous to within 5kHz.

This method of frequency estimation can, of course, be used in applications other than the system described above. Equally, finer divisions than half a symbol period may be made, to further improve the resolution of ambiguity.

Whilst the phasor D is unambiguous, it is much less accurate than the fine frequency phasor A due to the short averaging time used. Accordingly, it is used by the detection logic 3922 merely to resolve the frequency ambiguity in the fine frequency phasor A. The detection logic, on receipt of the fine frequency phasor A, detects which of the possible fine frequency values ($\alpha$, $\Delta F+\alpha$, $2\Delta F+\alpha$ etc) the coarse frequency phasor D is closest to, and selects that frequency value as correct.

The detection logic 3922 detects the maximum fine frequency phasor from each of the frequency estimators 3921; and if the maximum phasor A is found on the same estimator output for two of the last three estimates then acquisition is established, if the corresponding three frequency estimates (using the coarse phasor to resolve the ambiguity) are within 20Hz of each other.

It is found that the coarse frequency estimators 3924 are sufficiently noisy that it may take an undesirably long time for the average, over time, coarse frequency estimate phasor D to reach a constant level. However, it is found that in 99.7% of cases, after less than ¼ second, only two possible coarse frequency estimates need be considered; the possible fine frequency phasor closest to the coarse frequency phasor typically dithers between the same two values.

Accordingly, the detection logic 3922 measures, over time, the commonest occurring coarse frequency estimator values, from the frequency estimator 3921 which is detected to be carrying the reference symbols, calculates two frequency estimates using the two dithering values of the fine frequency phasor A, and supplies the corresponding two frequencies to the two multipliers 394a,394b.

Since one of the two frequencies is 99.7% likely to be correct, one of the unique word detectors 398a, 398b will detect the start of a frame within half a second, at which time the frequency on which the unique word was detected is accepted as the correct reference subcarrier frequency.

It will therefore be seen that the frequency estimation process described herein is capable of both accurate frequency estimation (due to the three stage delay-multiply-add process) and low ambiguity. The ambiguity resolution over a bandwidth greater than the symbol repetition period is achieved by splitting each symbol period into fractions, so as to pass within each fraction a bandwidth which is a multiple of the symbol repetition frequency. This also enables resolution on the order of the symbol repetition rate whilst working at the much slower reference symbol repetition rate, which reduces the processing capability required.

It will be apparent that the coarse frequency estimate could be derived without the use of fine frequency phasor A by taking the difference between the phasors B and C (corresponding to the phase change over one symbol period). However, this is not preferred, for two reasons. Firstly, both the phase of B and C are noisy, and the use of the fine frequency phasor A reduces somewhat the noise in the result. Secondly, the use of the fine frequency phasor A enables the phase change over half a symbol period to be extracted (rather than over one symbol period), thus increasing the range over which the phasor is unambiguous.

Having acquired the unique word, the frequency is completely acquired and the start of the frame period is established. The data following the unique word on the reference channel is then decoded by whichever preliminary detector 383x or 383y is receiving the correct frequency, and supplied to the ensemble plan receiver 373 which reads the number of channels and subcarriers present. The ensemble plan receiver 373 then sets up the receive filter 335 with a bandwidth sufficient for the ensemble to be received, and the frequency estimate is supplied to the multiplier 371. Operation of the receiver of Figure 18 then continues as described.

Referring to Figure 27, the deformatter 370 receives, in parallel, the subcarriers generated by the baseband processing circuit of 330 of Figure 21. A reference symbol extracting circuit 328 extracts every fourth and fifth symbol on the reference subcarriers and subtracts the fourth from the fifth, so as to eliminate the reference information and reconstitute the data symbol. The symbols from the subcarriers are then time multiplexed onto a sample de-interleaver circuit 327. The sample de-interleaver circuit 327 is functionally the reverse of the bit interleaver circuit 127 at the transmitter, and comprises 64 columns and c rows (where c is the number of channels).

At the same time as the samples are read into the sample de-interleaver 327, the sample powers or amplitudes are accumulated in a summer 329. The accumulated power for each group of samples (corresponding to a sample from each of the channels) is used to control the gain of an amplifier 329b so as to perform automatic gain control, prior to quantization to 3 bits in a quantizer 329c. Performing the power integration whilst reading the samples into the de-interleaver 327 avoids the need for further delay due to automatic gain control.

The coarsely quantized samples are then fed, through a zero stuffing circuit 326 (which inserts zeros to compensate for the code puncturing circuit 126 at the transmitter), to a Viterbi decoder 325. Where the convolutional coder is the above mentioned STEL-2040 ASIC, the Viterbi decoder 325 may be performed by the same component.

The stream of bits from the Viterbi decoder 325 are fed through a descrambler 324 (e.g. a standard V.35 descrambler integrated circuit) operating to reverse the scrambling performed by the scrambler 124 at the transmitter, and the descrambled bit stream is distributed amongst a datagram output 304, a B4 encoded output port 303b, and a B6 stream which is padded intermittently with zeros by a fill circuit 323 (to fill the bits punctured at the transmitter by the puncture circuit 123) byte de-interleaved by a de-interleaver circuit 323 comprising a random access memory and addressing circuitry functionally identical to the byte interleaver 122 at the transmitter, and Reed-Solomon decoded by a decoder circuit 321 (which, when the encoder is the LSI logic L64711, may be the LSI logic L64714 integrated circuit device). The decoded output stream of bits is distributed amongst parallel pins of the B6 output port 303a.

The decoding process is illustrated in steps 2005-2001 of Figure 10b.

Alternative receiver embodiments

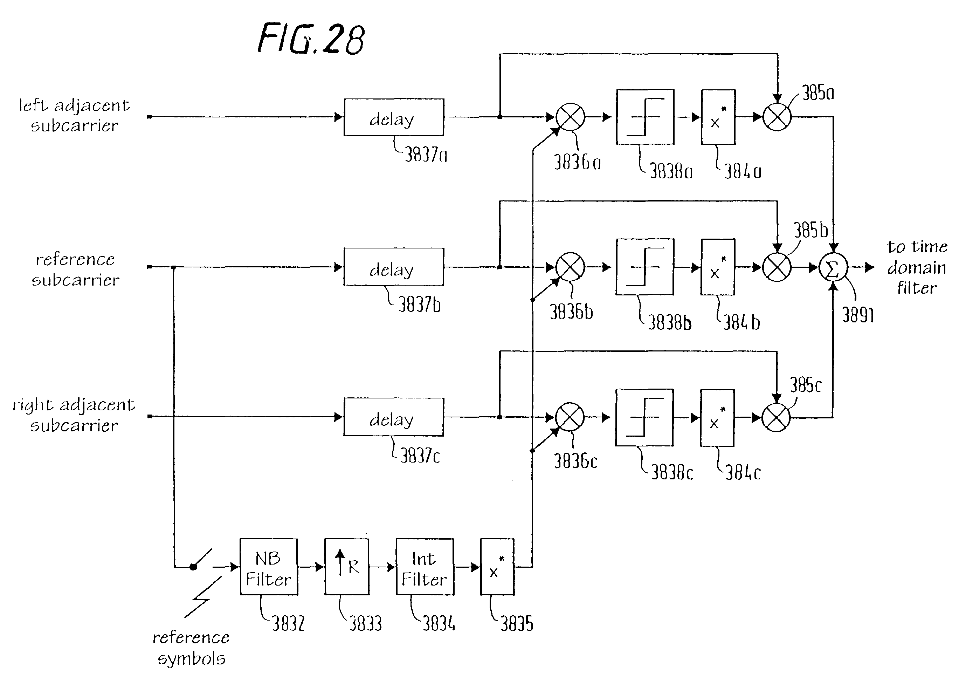

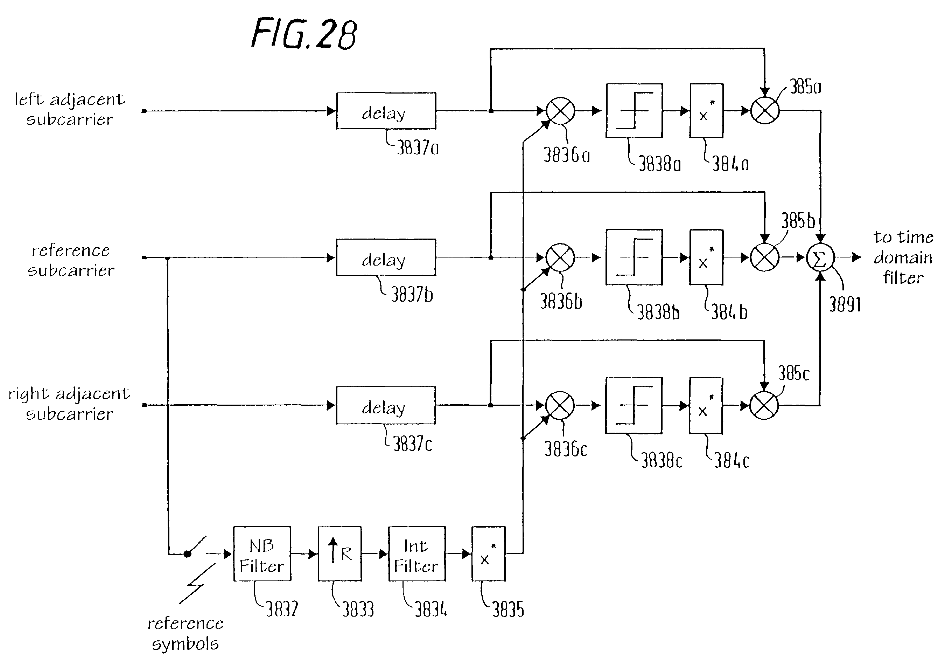

Referring to Figure 28, the channel compensation performed in the baseband processing circuit shown in Figure 21 can be improved if the channel estimate on each reference subcarrier takes account of channel information from the neighbouring subcarriers.

As shown in Figure 28, in this case, the structure of the preliminary detector of Figure 22 is modified so that the conjugate of the channel response derived from the reference subcarrier is fed to a respective multiplier 3836a-c on the reference subcarrier and each of the subcarriers which neighbour it in frequency. A preliminary decision is then performed by a hard decision circuit 383a-383c on each of the subcarriers, and the signal from each of the subcarriers is multiplied by the conjugate of the symbol decision at a respective multiplier 385a-385c.

The result, on each subcarrier, is a series of channel samples which are summed together at a summing node 3891 to provide an improved channel estimate supplied to the time domain filter 387 for the reference subcarrier.

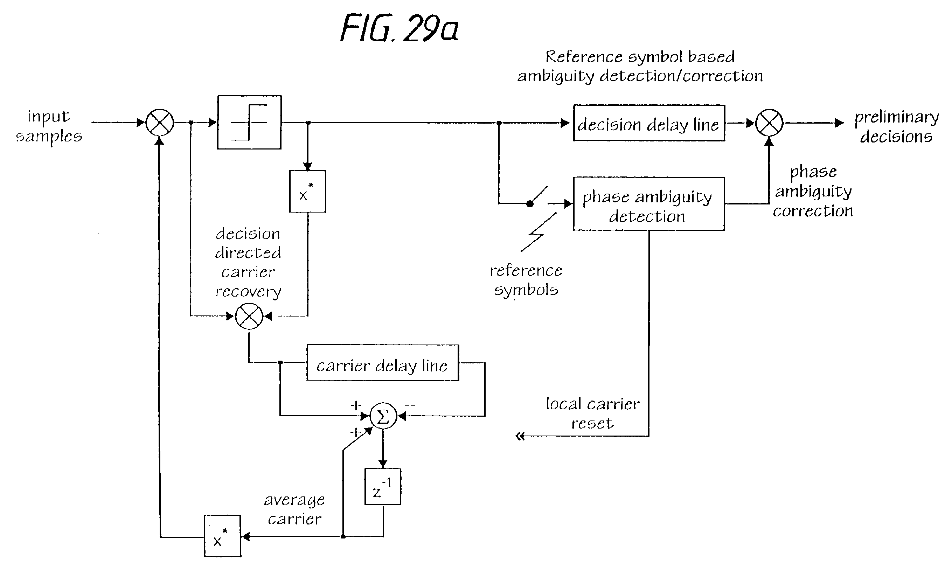

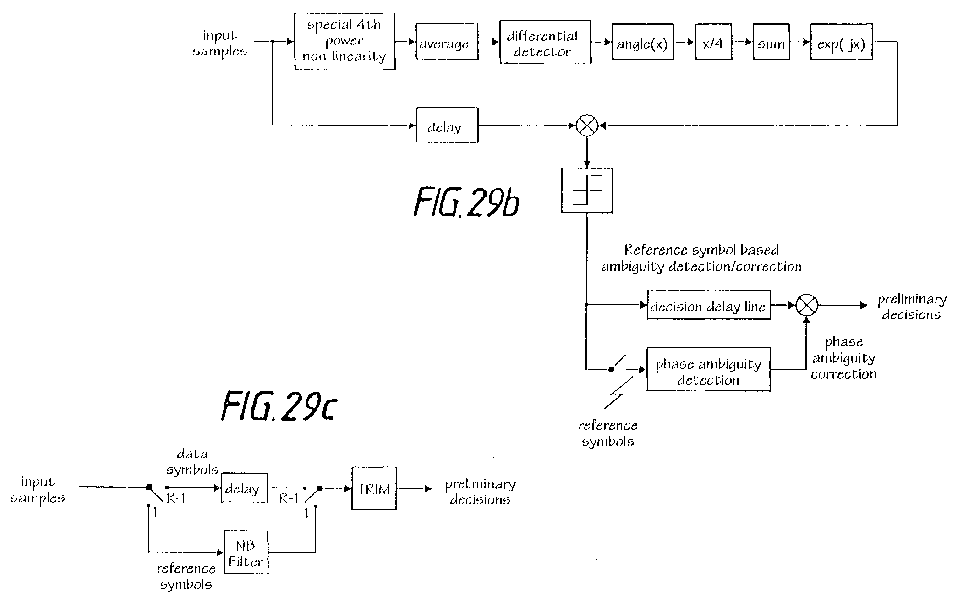

Referring to Figures 29a-c, different preliminary detector architectures are equally possible to that shown in Figure 22.

For example, the circuit shown in Figure 29a comprises a decision directed carrier recovery circuit, in which the input signal is first multiplied by the conjugate of the local reference and then detected. The decision is used to recover the current carrier sample, and a sliding window is used to produce an average carrier sample over a number of past symbol periods. The average carrier serves as the local reference of the next detection. The detected data is passed to ambiguity detection and correction logic where it is delayed by a number of samples equalling 1.5 times the reference symbol rate. The output of the delay line is multiplied by an ambiguity correction signal and the resulting signal represents a preliminary decision generated by the detector. While the detected data is held within the delay line, the reference symbols are monitored to detect phase ambiguities. A correctly detected reference symbol is declared when the current detection agrees with either of the previous reference symbol.

Figure 29b shows a Viterbi and Viterbi type preliminary detector, as disclosed in greater detail in "Non linear estimation of PSK-modulated carrier phase with applications to burst digital transmission", IEEE Trans. Inform. Theory, Vol. IT-29, No. 4, pp. 543-551, July 1983. In this type of detector, the carrier phase estimated is computed by removing the transmitted modulation using a special fourth power non linearity which maintains the input vector magnitude but multiplies its phase by four. Further details are to be found in the above referenced paper.

Figure 29c shows a TRIM detector, which computes a maximum likelihood estimate of the data over a block consisting of a reference sample and a number of data samples, given an appropriate weighted reference sample. Further details of this type of device are disclosed in S. Crozier and R. Young, "Low complexity non-coherent multi-symbol detector for DMSK signals with maximum likelihood performance", Proceedings of the International Conference on Wireless Communications (Wireless '93), Calgary, Alberta, pp. 367-375, July 1993.

Other possible detectors could be used; for example as described in D. Divsalar and M.K. Simon, "Multiple-symbol differential detection of MPSK", IEEE Trans. Commmun, vol. 38, no. 3, pp. 300-308, March 1990, or K. Mackenthun, "A fast algorithm for maximum likelihood detection of QPSK or $\pi$/4-QPSK Sequences with unknown phase", 3rd International Symposium on Personal, Indoor and Mobile Radio Communications, Boston, Massachusetts, pp. 240-244, October 1992.

Although the above described frequency tracking and frequency estimator circuits have been described for use with a signal which includes reference symbols, it will clear that, where (as disclosed above in relation to the frequency tracking circuit) the multiplexed signal is raised to a higher power M, reference symbols are not necessary. This is applicable equally to the frequency estimator circuit, which would then operate between first and second symbol periods (which might, for convenience, be spaced 4 or 5 symbol periods apart).

In the frequency tracking and frequency acquisition circuits and elsewhere in the receiver, the above description illustrates how reference symbols all having the same, zero, phase may be used. If reference symbols with non zero phase are used, the receiver may at each stage include a subtracter for subtracting the known reference symbol phase from the received reference symbol phase, to form a measure of the phase due to the channel. This is equally applicable where the value of the reference symbol changes over time (as may well be desirable in some applications); in this case, the receiver stores the sequence of known reference symbol phase values and subtracts them in turn from the received reference symbol phase.

Although in the foregoing description the use of guard bands having an amplitude different to the average signal amplitude (e.g. zero value guard bands) has been disclosed, it would be possible to use guard bands having predetermined phase, rather than amplitude, behaviour and to perform long term phase discrimination rather than amplitude discrimination to detect the guard bands for symbol synchronisation.

Although in the foregoing description the Fourier Transformer is used to demodulate the OFDM signal for all multiplex sizes, which is preferred on ground of reduced complexity at the receiver, it is equally possible to provide a set of filters arranged to perform the inverse of the pulse shaping filters at the transmitter, and selected where the received multiplexed signal consists only of a few subcarriers. This provides a slightly improved performance.

<u>Satellite orbit considerations</u>

Where the satellite 200 generates a plurality of spot beams, as for example where the satellites are in low earth orbit (LEO) or intermediate circular orbits (ICO) at, for example, 10,000 kilometres altitude, the same receiver 300 may receive signal from more than one satellite. Particularly, where the satellites are moving or where the receiver 300 is moving, a handover from one satellite to another may be required.

Since the different satellites may be operating at slightly different frequencies due to the Doppler shift caused by the satellite movement or the movement of the receiver 300, and since the different path lengths to the receiver from the different satellites will lead to slightly different timing, it is advantageous to provide the receiver 300 with a plurality of (for example 2) acquisition circuits 390. Each acquisition circuit 390 acquires the signal from only one satellite, and the receiver includes a decision circuit for switching reception from the satellite acquired by the current acquisition circuit to the satellite acquired by the alternative acquisition circuit on the basis of number of errors received, signal strength, geographical position, or some other criterion.

In one method of implementing a non geostationary satellite system, channel frequencies are assigned based on a pattern of regions on the earth's surface. Therefore, at any given location, a given service will always be transmitted in a single given frequency channel regardless of which satellite is servicing that location. The satellite beams may be continuously steered to remain pointing at a particular region on the earth's surface. At some point, the satellite may pass the frequencies in question over to another satellite. In one embodiment according to the present invention, on each occasion where a group of frequencies corresponding to a geographical area are handed over from one satellite to the next in this manner, the first satellite may increase the speed of transmission of services for a period prior to handover, for example, by expanding the number of channels in the multiplexed signal, thus allowing the receiver 300 to buffer information prior to handover to decrease the loss of information whilst re-acquiring the second satellite.

Other alternatives and modifications

It will be apparent that many modifications and substitutions may be made to the above-described embodiments without departing from the invention. Some particular examples will now be described.

Rather than using zero-valued guard samples, any other values which do not coincide with the average data symbol magnitude may be used.

Reference information may be added to every subcarrier, or to some number other than every third and likewise, may be added more or less frequently than every fifth data symbol. Rather than employing constant-valued reference information, a sequence of values known to the transmitter and receiver may be used.

Other types of Reed-Solomon code may be used (e.g. a (255,239) code or a (255,213) code).

Equally, other types of forward error correcting code could be used, or convolutional coding alone could be relied on. Equally, parallel concatenated recursive systemic convolutional codes with interleaving between the component codes ("Turbo" codes), as described in "New Shannon Limit Error Correcting Coding and Decoding Turbo codes", C. Berron, A. Glavieux and P. Thitimasajshima; Proc. ICC '93, May 1993 (and performed by the CAS 5093 codec available from ComAtlas, France) may be used.

Rather than merely using pulse shaping filters in the case of small numbers of subcarriers, it would also be possible to use pulse shaping filtering on the edge subcarriers of a multiplexed signal of any kind, producing the other subcarriers either using an Inverse Fourier Transformer, or some other suitable means.

Where the invention is employed with spot beams from satellites, it may be desirable to modify the above embodiment to improve the bandwidth efficiency (possibly at a cost in power efficiency). This may be achieved by increasing the puncturing rate to achieve a rate of 3/4 (i.e. puncturing 1/3 of the bits), using for example, the 2 in 6 mask described in "Rate-Compatible Punctured Convolutional codes (RCPC Codes) and their applications", J. Hagenauer; IEEE Trans. Commun., Vol 36, pp 389-400, April 1998.

Although phase shift keying (PSK) using two or four states has been described, it is equally possible to extend the invention to use more phase states (for example 8-PSK). Alternatively, other modulation schemes such as quadrature amplitude modulation (QAM) may be used. So called "pragmatic coding" techniques, described in "A pragmatic approach to trellis-coded modulation", Viterbi et al, IEEE Communications Magazine, 1989 may be used on the in-phase and quadrature components separately.

In one particular embodiment a 16-QAM constellation is employed, and groups of four bits are encoded, the first two bits being encoded in the in phase (I) component and the second two bits in the quadrature (Q) component. Within the bits coded in each component, the first bit is a sign bit (i.e. plus or minus) and the second bit is an amplitude level bit. This scheme gives a spectral efficiency of two bits per symbol.

Since QAM signals, unlike PSK signals, do not have constant envelope, rather than multiplying by the complex conjugate to correct for the phase of the channel, the receiver effects a complex division to correct the phase and normalise the amplitude of the sample with respect to the channel.

In each of the in phase and quadrature channels, pulse amplitude modulation may be used, with a first number of levels ($M_I$) in the in phase channel and a second number of levels ($M_Q$) in the quadrature channel. Where two channels are present on a subcarrier, this in general produces quadrature amplitude modulation, and where only a single channel is present (i.e. the in phase channel) this results in M-level pulse amplitude modulation.

Whilst a method of combining the reference information with data symbols has been described utilising the Hadamard transformation, other orthogonal transformations which combine the reference and data streams orthogonally, over more than one symbol period, may be employed.

Whilst a transmitter which can vary the size of the ensemble of subcarriers, and a receiver which can operate with a variable number of subcarriers, have both been described, it will be recognised that it would be possible to provide in the system at least one transmitter which operates only with a fixed predetermined ensemble size, and such a transmitter is within the scope of the present invention; likewise it would be possible to provide a receiver capable of receiving only one ensemble size (although in this case the receiver would only be capable of receiving certain signals within the scope of the invention).

Although the peak to mean reduction circuit 132 and peak clipper circuit 136 of the transmitter have been described as separate, successive, stages it will be clear that they could in fact be performed at one and the same time by a single calculating device (e.g. DSP device) in a single calculation stage. It will equally be apparent that, rather than employing thresholds and linear attenuation as described, an appropriate non-linear attenuation could be employed to achieve a similar effect.

Although the transmitter and receiver stations described above each include all the elements necessary for respectively transmission or reception, it will be recognised that, as is conventional in electrical systems, the elements of each station could be dispersed to several physically separate locations; elements of each system could even be positioned in orbit on one of the satellites 200. The present invention therefore extends to parts and sub-components of the inventive system described therein.

Whilst broadcasting has been described, the invention could also be used in one-to-one (narrow casting) telecommunications, or even for storage and reading of data onto a record medium (e.g. a magnetic disc).

In particular, the invention can advantageously be employed in asymmetrical communications, in which large volumes of data are transmitted downwards (to a user) from, for example, a database host storing files of image, text and/or sound data (for example, in a multimedia format) and a narrow bandwidth return (uplink) signalling channel is provided to enable users to request the transmission of such data.

Thus, mobile terminal users can gain access to high bandwidth services such as video-on-demand, or access to the Internet. The return signalling channel could use any convenient technology (for example, it could be an Aloha channel at a frequency different from, or unused by, the multiplex).

In such asymmetric systems, the OFDM transmitter does, of course, still broadcast the multiplex signal, but some address or identification data indicates the particular receiver or receivers for which it is intended, and those receivers ignore signals not addressed to them. Alternatively, the multiplex may be selectively encoded or encrypted for access only by such receivers, which therefore contain corresponding decoders or decrypters, of known type.

Accordingly, in the light of the foregoing and other embodiments apparent to the skilled man, the invention is not to be limited to the above described embodiments.

## Claims

1. A signal broadcasting RF transmitter apparatus comprising means for generating an RF frequency-multiplexed signal comprising a plurality of frequency-spaced subcarriers in a band, **characterised by** means for periodically inserting data specifying the subcarriers present onto a first, predetermined, subcarrier.

2. Apparatus according to claim 1, further comprising means for varying the number of said transmitted subcarriers.

3. Apparatus according to claim 1 or 2, in which the first subcarrier is at a predetermined, frequency-constant, spectral position relative to the edge of the band irrespective of the number of subcarriers.

4. Apparatus according to claim 3, in which the first subcarrier is located edgemost, at a constant frequency, in the band.

5. Apparatus according to any of claims 1 to 4, comprising means for modulating each said subcarrier.

6. Apparatus according to claim 5 in which one said channel is modulated onto one of a pair of quadrature components of said subcarrier.

7. Apparatus according to claim 6 in which each said channel amplitude-modulates the respective quadrature component of said subcarrier.

8. Apparatus according to claim 7 in which said amplitude modulation is binary.

9. Apparatus according to any of claims 1 to 5, comprising means for modulating at least two data channels onto a subcarrier to form each symbol thereon.

10. Apparatus according to any of claims 6 to 9, in which all channels contribute the same energy to said signal.

11. Apparatus according to any of claims 6 to 10 further comprising means for allocating channels to subcarriers such as to provide; at least one outer edge subcarrier carrying either one or two channels in dependence on whether the number of channels is odd or even, and, where the number of channels exceeds three, one or more inner subcarriers between said outer edge subcarrier and said reference subcarrier, each inner subcarrier carrying two channels.

12. Apparatus according to any preceding claim, comprising means for selectively applying either BPSK or QPSK modulation at the same symbol rate to a subcarrier.

13. Apparatus according to any preceding claim, comprising a configurable filter with a pass band set in dependence upon the number of subcarriers present.

14. A frequency-multiplexed RF signal comprising a plurality of frequency-spaced subcarriers, **characterised in that** it includes a first subcarrier at a predetermined frequency and **in that** said first subcarrier carries periodic data specifying the other subcarriers present in the frequency multiplexed signal.

15. An orthogonal frequency multiplexed RF signal carrying a first plurality of channels on a second, smaller, plurality of subcarriers, each channel modulating a quadrature component of one of said subcarriers.

16. A signal according to claim 15 in which said channels amplitude modulate said subcarriers.

17. An RF receiver apparatus comprising means for receiving an RF frequency multiplexed signal comprising a plurality of frequency-spaced subcarriers in a band, **characterised by** means for reading data specifying the subcarriers present from a first, predetermined, subcarrier and for configuring the receiver to receive said subcarriers.

18. Apparatus according to claim 17 comprising a configurable filter with a pass band set in dependence upon said data.

19. An OFDM receiver comprising a demodulator for demodulating a first plurality of channels from a second, smaller, plurality of subcarriers, said demodulator being arranged to demodulate each channel from one quadrature component of one subcarrier.

20. A frequency multiplexed RF signal comprising a plurality of frequency-spaced subcarriers each being modulated in a succession of data symbol periods, at least one said subcarrier being a reference subcarrier carrying orthogonal data and reference sequences of data and reference symbols respectively, in reference symbol repetition periods each of a duration of a multiple of the data symbol period duration, **characterised in that**, in at least first and second symbol periods within each reference symbol repetition period, the symbols carried on said reference subcarrier comprise combined symbols comprising respectively first and second different combinations of the same, repeated, data and reference symbols, said first and second combinations providing said orthogonality and permitting the separation of said data and reference symbols.

21. A signal according to claim 20 in which said reference symbols on one said reference subcarrier do not vary over time.

22. A signal according to claim 20 or claim 21, in which the amplitude of said combined symbols is the same as that of said data symbols.

23. A signal according to any of claims 20 to 22, in which the combined sample in said first symbol period is proportional to the sum of the data and reference symbols, and that in said second is proportional to the difference therebetween.

24. A signal broadcasting RF transmitter apparatus comprising a modulator arranged to modulate a plurality of frequency-spaced subcarriers with information in a succession of data symbol periods, said modulator being arranged to receive orthogonal sequences of data and reference information and to modulate at least one said subcarrier as a reference subcarrier with combined symbols comprising respectively first and second different combinations of the same, repeated, data and reference symbols, in different symbol periods, said first and second combinations providing orthogonality between said data and reference symbols and permitting the separation of said data and reference symbols at a receiver.

25. Apparatus according to claim 24 in which said reference symbols have a constant value over time on at least one said reference subcarrier.

**26.** Apparatus according to claim 24 or claim 25 in which the amplitude of said combined symbols is the same of that of said data symbols.

**27.** Apparatus according to any of claims 24 to 26, in which the combined sample in a first symbol period is proportional to the sum of the data and reference symbols, and that in a second symbol period is proportional to the difference therebetween.

**28.** A receiver for a frequency multiplexed RF signal comprising a plurality of frequency- spaced subcarriers each being modulated in a succession of data symbol periods, a least one said subcarrier being a reference subcarrier carrying orthogonal data and reference sequences of data and reference symbols respectively, in reference symbol repetition periods each of a duration of a multiple of the data symbol period duration, the receiver comprising means for combining the symbols received on said reference subcarriers in at least first and second symbol periods within each reference symbol repetition period to generate first and second combinations therefrom, a first combination recovering a data symbol and a second combination recovering a reference symbol, said first and second combinations providing orthogonality and permitting the separation of said data and reference symbols.

**29.** A receiver according to claim 28 further comprising a synchronous demodulator arranged to utilise said reference symbols to demodulate said data symbols.

**30.** A frequency-multiplexed signal generator generating a frequency multiplexed signal which may have, selectively, either a first format comprising at least one subcarrier or a second format comprising more subcarriers than said first format, the signal generator comprising a first signal processing circuit generating said first format, a second signal processing circuit generating said second format, and a selection circuit selecting one or other of said first or second signal processing circuits.

**31.** A generator according to claim 30, comprising a modulator circuit for modulating said subcarriers at a symbol rate at which said subcarriers are substantially mutually orthogonal.

**32.** A generator according to claim 30 or claim 31 in which said first signal processing circuit comprises at least one pulse shaping filter.

**33.** A generator according to claim 32 in which said pulse shaping filter is arranged to receive an input subcarrier modulating data signal, and to shape the signal so as to concentrate the energy thereof within sample periods, between which guard intervals of reduced magnitude are inserted.

**34.** A generator according to claim 33 in which the frequency response of the pulse shaping filter is such as to produce a subcarrier in which the sidelobes are suppressed, relative to a $(\sin \chi/\chi)$ wave form.

**35.** A generator according to any of claims 30 to 34, in which said second signal processing circuit acts as a bank of $(\sin \chi/\chi)$ filters.

**36.** A generator according to any of claims 30 to 35, in which said second signal processing circuit performs an orthogonal transformation on a plurality of input subcarrier modulating data signals, to generate a time domain signal including said subcarriers.

**37.** A generator according to any of claims 30 to 36, in which said second signal processing circuit is an Inverse Fast Fourier Transformer.

**38.** A generator according to any of claims 30 to 37, in which said first format consists of one, two or three subcarriers and said second format consists of four or more subcarriers.

**39.** A generator according to any of claims 30 to 38, in which said second signal processing circuit is arranged to insert guard intervals of predetermined values at periodic intervals within said frequency multiplexed signal.

**40.** A multiplexed signal transmitter comprising a generator according to any of claims 30 to 39.

**41.** A satellite earth station comprising a transmitter according to claim 40.

**42.** A method of generating a frequency multiplexed signal, comprising the steps of selecting either a first signal format comprising a relatively small number of frequency multiplexed subcarriers or a second format comprising a larger number of subcarriers than the first; and either;

filtering one or more subcarrier input data signals using filters arranged to apply a relatively high degree of attenuation to the sidelobes of said subcarriers to produce said first format; or generating a plurality of subcarriers in such a manner as to pass at least part of the first sidelobe of each said subcarrier to produce said second format.

**43.** A method of generating a frequency multiplexed signal comprising:

selecting the number of subcarriers in said signal; and, in dependence on said selection, either applying pulse shaping filtering to a small number of input subcarrier modulating data signals to generate a first multiplexed format signal comprising a relatively small number of subcarriers; or applying an Inverse Fourier Transform to a relatively large number of input subcarrier modulating data signals, to generate a frequency multiplexed signal in a second format comprising relatively large number of said subcarriers.

**44.** A frequency multiplexed signal generator comprising:

one or more pulse shaping filters;
a Inverse Fourier Transformer; and
a selector operatively coupled to interconnect input subcarrier modulating signals to either said one or more pulse shaping filters or said Inverse Fourier Transformer.

**45.** A frequency multiplexed signal receiver comprising a first signal processing circuit for receiving a frequency multiplexed signal in a first format consisting of a small number of subcarriers, and a second signal processing circuit for receiving a frequency multiplexed signal in a second format comprising a larger number of subcarriers.

**46.** A receiver according to claim 45 in which the first signal processing circuit comprises at least one pulse shaping filter and the second signal processing circuit comprises an Inverse Fourier Transformer.

**47.** An OFDM transmitter comprising an OFDM generator for generating an ensemble of orthogonal, information-carrying frequency subcarriers, and a transmit filter for passing the subcarriers and at least a portion of the first sidelobes of the highest and lowest frequency subcarriers, and attenuating the second and subsequent sidelobes of said highest and lowest frequency subcarriers.

**48.** A transmitter according to claim 47, in which the filter has regular nulls which lie within said sidelobes, away from the nulls between said sidelobes.

**49.** A transmitter according to claim 47 or claim 48 comprising a control circuit for controlling the number of said subcarriers, and for controlling the bandwidth of said filter to match the number of said subcarriers.

**50.** A transmitter according to any of claims 47 to 49 in which the transition frequency of the filter passes through said first outer sidelobes of said highest and lowest frequency subcarriers.

**51.** A method of receiving an OFDM signal comprising filtering said signal to pass all the OFDM subcarriers and at least a portion of the first outer sidelobes of the highest and lowest frequency information-carrying subcarriers, and to attenuate frequencies outside the frequency of the second outer sidelobes of the said highest and lowest frequency subcarriers.

**52.** A method of filtering an orthogonal frequency division multiplexed signal comprising a plurality of orthogonal, information-carrying subcarriers each having a $(\sin \chi/\chi)$ spectral form, consisting of filtering said plurality of subcarriers so as to pass all said subcarriers and at least a portion of the first sidelobe of the highest and lowest subcarriers, and to attenuate the second and further sidelobes of said highest and lowest frequency subcarriers.

**53.** A method according to claim 51 or claim 52 in which the filtering transition frequency passes through the first outer sidelobes of the said highest and lowest frequency subcarriers.

**54.** A method according to any of claims 51 to 53 in which the filtering applies nulls within each of the second and further sidelobes, away from the nulls therebetween.

**55.** A receiver for receiving an OFDM signal comprising a filter with a pass band arranged to pass the subcarriers of said OFDM signal and at least a portion of the first outer sidelobes of the highest and lowest subcarriers present therein, and to attenuate frequencies corresponding to the spectral positions where the second and further outer sidelobes of said highest and lowest frequency subcarriers would be.

**56.** A receiver according to claim 55 further comprising a control circuit for setting the bandwidth of said filter between at least first and second different values corresponding to at least first and second respective different numbers of subcarriers.

**57.** A receiver according to claim 55 or claim 56 which the transition frequency of the filter passes through said first outer sidelobes of said highest and lowest frequency subcarriers.

**58.** A receiver according to any of claims 55 to 57 in which the filter has regular nulls which lie within said sidelobes, away from the nulls between said sidelobes.

**59.** An OFDM signal comprising a plurality of orthogonal information-bearing subcarriers, the first outer sidelobes of the highest and lowest frequency said subcarriers being partially attenuated by filtering.

**60.** A method of processing an orthogonal frequency multiplexed signal modulated in symbol periods comprising:

a first step of reducing the magnitude of the signal over a symbol period so as to maintain orthogonality, and where necessary, a second step of reducing the magnitude of particular temporal portions of the signal relative to others so as to reduce the peak-to-mean ratio of the multiplexed signal.

**61.** A method according to claim 60 in which said first step comprises the steps of:
testing the signal magnitude against a first predetermined threshold; and, in the event that any temporal portion of a symbol period exceeds said first threshold, reducing all temporal portions of the symbol period by the same factor.

**62.** A method according to claim 61, wherein said factor is constrained not to exceed a second predetermined threshold and, in the event that said second predetermined threshold is not exceeded, said factor is such as to reduce the magnitudes of all temporal portions beneath said first predetermined threshold.

**63.** A method according to claim 62, in which said second step comprises the steps of comparing temporal portions of a symbol period, subsequent to processing by said first step, with a third predetermined threshold and, in the event that any of said temporal portions exceeds said third predetermined threshold, reducing said temporal portion magnitudes so as not to exceed said third predetermined threshold whilst leaving other temporal portion magnitudes, which do not exceed said third predetermined threshold, unmodified.

**64.** A method according to claim 63 in which said third predetermined threshold is higher than said first predetermined threshold.

**65.** An OFDM transmitter comprising:

a symbol power attenuator circuit (132) operable to evenly attenuate all successive samples of an OFDM symbol of excessive magnitude or peak to average ratio; and
a sample attenuator circuit (136) operable to selectively attenuate relatively high magnitude samples within the symbol period.

**66.** A receiver for a frequency multiplexed signal comprising a plurality of frequency subcarriers carrying information in symbol periods and having intervals of predetermined amplitude between said symbol periods, the receiver comprising a signal timing circuit arranged to generate a timing signal permitting the recovery of the information, said signal timing circuit being responsive to said intervals, said recovery being carried out on said multiplexed signal independently of the recovery of said subcarriers.

**67.** A receiver according to claim 66 in which the signal timing circuit comprises an averaging circuit arranged to generate a signal responsive to the long term average value of the received signal at a point in time within the symbol period and previous signal values at corresponding points in time within previous symbol periods.

**68.** A receiver according to claim 67 in which the averaging circuit comprises a leaky integrator.

**69.** A receiver according to claim 67 or claim 68 further comprising a high pass circuit receiving the output of said averaging circuit and generating an output signal responsive to transitions in the output of said averaging circuit.

**70.** A receiver according to claim 69 in which the high pass circuit comprises a differencer.

**71.** A method of acquiring the timing within a frequency multiplexed signal which comprises a plurality of subcarriers each modulated synchronously with information in symbol periods separated by intervals of a predetermined magnitude, the method comprising the step of detecting said intervals prior to separation or demultiplexing said signal.

**72.** A method according to claim 71 comprising the step of performing long term averaging of each signal value at a point in a symbol period and the corresponding signal values at corresponding points in previous symbol periods.

**73.** A method according to claim 72 further comprising the step of differencing the averaged signal to detect transitions therein.

**74.** A frequency acquisition circuit for acquiring the frequency of a signal modulated in a succession of symbol periods, and including first and second symbol periods, comprising:

a sampling circuit sampling over a fraction of each said symbol period;
a first frequency phasor circuit arranged to generate, responsive to said samples, an output signal indicative of the phase advance due to frequency offset between said first and second symbol periods over a first interval which is not an integral number of said symbol periods; and
a second frequency phasor circuit arranged to generate, responsive to said samples, an output signal indicative of the phase advance due to frequency offset over a second interval which is not equal to said first interval.

**75.** A circuit according to claim 74, in which said first and second intervals differ by no more than one symbol period.

**76.** A circuit according to claim 74 or claim 75 wherein said first and second intervals differ by no more than said fraction of a symbol period.

**77.** A circuit according to any of claims 74 to 76 wherein said fraction is approximately half of a symbol period.

**78.** A circuit according to any of claims 74 to 77 comprising a third frequency phasor circuit responsive to said samples to generate an output signal indicative of the phase advance over a third interval.

**79.** A circuit according to claim 78, wherein said second interval comprises an integral number of symbol periods and said first and third intervals comprise, respectively, a fraction of a symbol period more and a fraction of a symbol period less than said second.

**80.** A circuit according to any of claims 74 to 79 wherein each said frequency phasor circuit comprises a delay-multiply-average circuit.

**81.** A circuit according to any of claims 74 to 80 wherein the first and second symbol periods each include reference symbol data representing reference symbols of predetermined phase values, and the sampling circuit is timed to sample only said reference symbol data symbol periods.

**82.** A method of frequency acquisition for a signal modulated in symbol periods; comprising the steps of:

sampling symbol periods over fractions of their lengths, so as to pass frequencies higher than the reciprocal of the symbol period;
estimating the phase advance due to frequency offset over a first number of said samples and the phase advance due to frequency offset over a second number of said samples, said first and said second numbers corresponding to time periods which differ by an amount which is not an integer number of said symbol periods; and

forming a measure of the difference between the first and second phase advances to provide a frequency error estimate.

83. A method according to claim 82, wherein some of said symbol periods contain signals representing reference symbols recurring at regular intervals, and wherein said frequency error estimate is unambiguous over a frequency range greater than the reciprocal of the interval between reference symbols.

84. A method of decoding a convolutionally encoded and interleaved signal comprising the steps of:

sampling the signal;
reading each signal sample into a deinterleaver circuit in a first order;
reading each sample into a control circuit arranged to generate one or more control signals responsive to the level of each sample;
reading the samples out of the deinterleaver in a second order;
quantizing the samples; and
decoding the quantized samples;

**characterised by** reading said samples into said control circuit in parallel with the reading thereof into said deinterleaver circuit, and by the step of aligning the range of the quantizer with that of the samples prior to reading the samples out of the deinterleaver circuit.

85. A decoder circuit for an interleaved and convolutionally encoded signal comprising a deinterleaver arranged to receive successive samples of the received signal; a quantizer arranged to receive samples read out from the deinterleaver circuit; and a decoder arranged to decode the quantized samples; **characterised by** a range control circuit operably connected to receive the samples in parallel with the deinterleaver circuit and to derive control signals for aligning the range of the quantizer and that of the samples read into the deinterleaver circuit, prior to read out of the samples from the deinterleaver circuit.

86. A satellite broadcasting system comprising a ground based broadcasting system transmitting an orthogonal frequency multiplexed signal and a repeater satellite in non geostationary orbit.

87. A system according to claim 86 in which each repeater satellite is arranged to generate a plurality of spot beams.

88. A system according to claim 86 or claim 87 comprising handover control means for transferring a receiver between two said beams or two said satellites.

89. A system according to any of claims 86 to 88 in which the rate of transmission of data on said frequency multiplexed signal is increased prior to said handover.

90. A system according to claim 89 in which the number of subcarriers in said multiplexed signal is increased to increase the rate of transmission.

91. A ground station for a system according to any of claims 86 to 90.

92. A satellite for a system according to any of claims 86 to 90.

93. A receiver for a system according to any claims 86 to 90.

94. A receiver according to claim 93 comprising first and second acquisition circuits for acquiring signals from different said satellites.

FIG.1

FIG. 2

FIG. 3

# FIG. 4

Interleaver output
commutated across
the subcarriers

Frequency

0.504 secs frame

4.032 secs superframe

E = | unique word | ensemble plan |

Ē = | unique word | ensemble plan |

EP 1 161 025 A2

a) format of the multiplexed B6 stream

Reed Solomon input blocks

| 1 | 2 | ••• | M |
|---|---|-----|---|

| B6 stream1 | B6 stream 2 | ••• | B6 streamN | fill |
|------------|-------------|-----|------------|------|

# FIG.5

b) format of the multiplexed B4 stream

| B4 stream1 | B4 stream 2 | ••• | B4 stream N |
|------------|-------------|-----|-------------|

c) format of the multiplexed services stream

| datagrams | B6 stream multiplex | B4 stream multiplex | flush |
|-----------|---------------------|---------------------|-------|

## FIG.6a

```
                              transmitted subcarriers
     ensemble              MR=main ref; R,r=ref; D,d=data
     configur.            uppercase=full, lowercase=half
   ----------          ---------------------------------------------------
                        1  2  3  4  5  6  7  8  9 10 11 12 13 14 15 16 17
                       ---------------------------------------------------
        0              MR  .  .  .  .  .  .  .  .  .  .  .  .  .  .  .  .
        1              MR  d  .  .  .  .  .  .  .  .  .  .  .  .  .  .  .
        2              MR  D  .  .  .  .  .  .  .  .  .  .  .  .  .  .  .
        3              MR  D  d  .  .  .  .  .  .  .  .  .  .  .  .  .  .
        4              MR  D  D  .  .  .  .  .  .  .  .  .  .  .  .  .  .
        5              MR  D  D  r  .  .  .  .  .  .  .  .  .  .  .  .  .
        6              MR  D  D  R  .  .  .  .  .  .  .  .  .  .  .  .  .
        7              MR  D  D  R  d  .  .  .  .  .  .  .  .  .  .  .  .
        8              MR  D  D  R  D  .  .  .  .  .  .  .  .  .  .  .  .
        9              MR  D  D  R  D  d  .  .  .  .  .  .  .  .  .  .  .
       10              MR  D  D  R  D  D  .  .  .  .  .  .  .  .  .  .  .
       11              MR  D  D  R  D  D  r  .  .  .  .  .  .  .  .  .  .
       12              MR  D  D  R  D  D  R  .  .  .  .  .  .  .  .  .  .
       13              MR  D  D  R  D  D  R  d  .  .  .  .  .  .  .  .  .
       14              MR  D  D  R  D  D  R  D  .  .  .  .  .  .  .  .  .
       15              MR  D  D  R  D  D  R  D  d  .  .  .  .  .  .  .  .
       16              MR  D  D  R  D  D  R  D  D  .  .  .  .  .  .  .  .
       17              MR  D  D  R  D  D  R  D  D  r  .  .  .  .  .  .  .
       18              MR  D  D  R  D  D  R  D  D  R  .  .  .  .  .  .  .
       19              MR  D  D  R  D  D  R  D  D  R  d  .  .  .  .  .  .
       20              MR  D  D  R  D  D  R  D  D  R  D  .  .  .  .  .  .
       21              MR  D  D  R  D  D  R  D  D  R  D  d  .  .  .  .  .
       22              MR  D  D  R  D  D  R  D  D  R  D  D  .  .  .  .  .
       23              MR  D  D  R  D  D  R  D  D  R  D  D  r  .  .  .  .
       24              MR  D  D  R  D  D  R  D  D  R  D  D  R  .  .  .  .
       25              MR  D  D  R  D  D  R  D  D  R  D  D  R  d  .  .  .
       26              MR  D  D  R  D  D  R  D  D  R  D  D  R  D  .  .  .
       27              MR  D  D  R  D  D  R  D  D  R  D  D  R  D  d  .  .
       28              MR  D  D  R  D  D  R  D  D  R  D  D  R  D  D  .  .
       29              MR  D  D  R  D  D  R  D  D  R  D  D  R  D  D  r  .
       30              MR  D  D  R  D  D  R  D  D  R  D  D  R  D  D  R  .
       31              MR  D  D  R  D  D  R  D  D  R  D  D  R  D  D  R  d
       32              MR  D  D  R  D  D  R  D  D  R  D  D  R  D  D  R  D
                        ----------------------------------> Frequency
```

FIG. 6b

# FIG. 7

comp. period n-1 ———▸◂——— composite symbol period n ————▸◂——— comp. period n+1

◂——————— symbol period ———————▸◂ guard interval ▸

a) zero sample guard interval

zero samples

zero samples

◂——▸

receiver integration window

timing error without performance degradation

EP 1 161 025 A2

FIG.8

## FIG. 9

## FIG. 10

a)

1001 — Outer Code (Reed Solomon)

1002 — Symbol Inter-leave

1003 — Inner Code (convol-utional)

1004 — Puncture

1005 — Bit Interleave

b)

2005 — Bit Deinter-leave

2004 — Zero stuffing

2003 — Inner Decoder (convol-utional)

2002 — Symbol Deinter-leave

2001 — Outer Decoder (Reed Solomon)

## FIG.11

160 information bytes

M information bytes

160-M fill bytes

192 bytes

RS block 1  
RS block 2  
RS block 3  
RS block 4

RS block N-3  
RS block N-2  
RS block N-1

N RS blocks

32 parity bytes

32 parity bytes

## FIG. 12

SCRAMBLER

INITIAL STATE REPRESENTED

| 1 | 1 | 0 | 1 | 0 | 0 | 1 | 0 | 1 | 0 | 1 | 1 | 0 | 0 | 1 |

Input Data

## FIG. 13

input bits

G1 → first code bit

G2 → second code bit

FIG. 14

EP 1 161 025 A2

Power spectrum

FIG.15a

EP 1 161 025 A2

OFDM signal (16 cars, 4 guard) with tight ensemble filter

FIG.15b

EP 1 161 025 A2

single subcarrier signal processing    *FIG.16a*

input
bits → [bits to symbols ⌐1391a] → [pulse shaping filter ⌐1392a] →

⌐1392a
⌐139a

two subcarrier signal processing    *FIG.16b*

⌐139a

⌐1391a
input
bits

[bits to symbols ⌐1391a] → [pulse shaping filter ⌐1392a]    main reference subcarrier

[bits to symbols ⌐1391b] → [phase compensation ⌐1394b] → [pulse shaping filter ⌐1392b] → [frequency translation ⌐1393b]

⊕ 139d

⌐139b

EP 1 161 025 A2

three subcarrier signal processing

## FIG. 16c

main reference subcarrier

139a

1391a

| bits to symbols |

1392a

| pulse shaping filter |

139e

| delay |

1391b 1394c 1395 1396 1397 1393c

input bits

| bits to symbols | → | phase compensation | → | rect. pulse shaping | → | guard insertion | → | lowpass filter | → | frequency translation |

139d

139c

1391c

| bits to symbols | → | phase compensation | → | pulse shaping filter | → | delay | → | frequency translation |

1394b 1392b 139f 1393b

139b

139

EP 1 161 025 A2

FIG.17

EP 1 161 025 A2

# FIG. 18

# FIG.19

filtered
rx signal
at 36 samples
per symbol

$|x|^2$   3741

lowpass filter   3745   3742

3743   $z^{-T}$

3744   $c$

differentiator   3748   3746

3747   $z^{-1}$

timing
correction
logic   3749

timing
control
signal

EP 1 161 025 A2

FIG. 20

# FIG.21

## FIG.22

input samples → delay 3837 → ⊗ 3836 → 3838 → preliminary decisions

3831

reference symbols → NB Filter 3832 → ↑R 3833 → Int Filter 3834 → ×* 3835

## FIG.24

filtered rx signal at 32 samples per symbol and centered at main reference subcarrier → $\sum_{i=1}^{16} \times$ → 3921a → DMA frequency estimator → coarse and fine frequency phasors

→ DMA frequency estimator 3921b

→ DMA frequency estimator 3921c

→ DMA frequency estimator 3921d

→ DMA frequency estimator 3921e

→ Detection logic → Two frequency estimates over +/- 1 channel spacing

3922

FIG.23

# FIG.25

# FIG.26

a) long and short delay phasors relative to the ambiguous phasor

long delay phasor
B

A ambiguous phasor

short delay phasor
C

direction of rotation

b) long and short delay phasors after rotation by the ambiguous phasor

long delay phasor
B

ambiguous phasor
A

short delay phasor
C

c) final unambiguous frequency phasor

D unambiguous phasor

$B + C^*$

ambiguous phasor
A

# FIG. 27

FIG.28

left adjacent
subcarrier

delay
3837a

3836a

3838a

384a

385a

reference
subcarrier

delay
3837b

3836b

3838b

384b

385b

to time
domain
filter

right adjacent
subcarrier

delay
3837c

3836c

3838c

384c

385c

3891

reference
symbols

NB
Filter
3832

↑R
3833

Int
Filter
3834

x*
3835

EP 1 161 025 A2

FIG.28

to time domain filter

3891

385a

385b

385c

384a

384b

384c

3838a

3838b

3838c

3836a

3836b

3836c

3837a

3837b

3837c

delay

delay

delay

3835

Int Filter — 3834

↑R — 3833

NB Filter — 3832

reference symbols

left adjacent subcarrier

reference subcarrier

right adjacent subcarrier

# FIG. 29a

Reference symbol based
ambiguity detection/correction

input samples → ⊗ → [⊓_ step] → decision delay line → ⊗ → preliminary decisions

x*

decision
directed
carrier
recovery

⊗

carrier delay line

+ (Σ) −
+

z^{-1}

average
carrier

x*

reference
symbols

phase ambiguity
detection

phase
ambiguity
correction

local carrier
reset

EP 1 161 025 A2

58

input samples → special 4th power non-linearity → average → differential detector → angle(x) → x/4 → sum → exp(-jx)

delay → ⊗

## FIG.29b

Reference symbol based ambiguity detection/correction

decision delay line → ⊗ → preliminary decisions

phase ambiguity detection → phase ambiguity correction

reference symbols

## FIG.29c

input samples → data symbols — R-1 → delay → R-1 → TRIM → preliminary decisions

1 → NB Filter → 1

reference symbols